(19) Europäisches Patentamt
European Patent Office
Office européen des brevets

(11) EP 4 213 318 A1

(12) # EUROPEAN PATENT APPLICATION
published in accordance with Art. 153(4) EPC

(43) Date of publication:
**19.07.2023 Bulletin 2023/29**

(21) Application number: **21866818.4**

(22) Date of filing: **09.09.2021**

(51) International Patent Classification (IPC):
***H01S 3/10*** *(2006.01)* ***G02F 1/35*** *(2006.01)*
***H01S 3/30*** *(2006.01)* ***H01S 5/50*** *(2006.01)*

(52) Cooperative Patent Classification (CPC):
**G02F 1/35; H01S 3/10; H01S 3/30; H01S 5/50**

(86) International application number:
**PCT/JP2021/033116**

(87) International publication number:
**WO 2022/054860 (17.03.2022 Gazette 2022/11)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **09.09.2020 US 202063076085 P**

(71) Applicant: **FURUKAWA ELECTRIC CO., LTD.**
**Chiyoda-ku**
**Tokyo 100-8322 (JP)**

(72) Inventors:
- **OGOSHI, Haruki**
  **Tokyo 100-8322 (JP)**
- **YOSHIDA, Junji**
  **Tokyo 100-8322 (JP)**
- **INABA, Yusuke**
  **Ichihara-shi, Chiba 290-8555 (JP)**
- **KIMOTO, Tatsuya**
  **Tokyo 100-8322 (JP)**
- **FUNABASHI, Masaki**
  **Tokyo 100-8322 (JP)**
- **ICHINO, Seiji**
  **Tokyo 100-8322 (JP)**
- **HOJO, Naoya**
  **Ichihara-shi, Chiba 290-8555 (JP)**
- **TAKASAKA, Shigehiro**
  **Tokyo 100-8322 (JP)**
- **SUGIZAKI, Ryuichi**
  **Tokyo 100-8322 (JP)**
- **THUDSALINGKARNSAKUL, Nitidet**
  **Phranakorn Sri Ayutthaya 13210 (TH)**
- **ANANTATHANASARN, Sanguan**
  **Phranakorn Sri Ayutthaya 13210 (TH)**

(74) Representative: **SSM Sandmair**
**Patentanwälte Rechtsanwalt**
**Partnerschaft mbB**
**Joseph-Wild-Straße 20**
**81829 München (DE)**

(54) **LIGHT SOURCE, LIGHT SOURCE DEVICE, METHOD FOR DRIVING LIGHT SOURCE, RAMAN AMPLIFIER, AND RAMAN AMPLIFICATION SYSTEM**

(57) To provide a light source, a light source device, and a light source driving method capable of simultaneously suppressing RIN and ripple, and a Raman amplifier and a Raman amplification system using the light source, the light source device, and the light source driving method. The light source includes a seed light source that outputs incoherent seed light with a predetermined bandwidth, and a booster amplifier as a semiconductor optical amplifier that optically amplifies the seed light input from a first facet, and outputs the amplified seed light as amplified light from a second facet. The first facet and the second facet of the booster amplifier are subjected to a reflection reduction treatment, the booster amplifier operates in a gain saturated state, and relative intensity noise (RIN) and ripple are simultaneously suppressed in the amplified light.

FIG.1

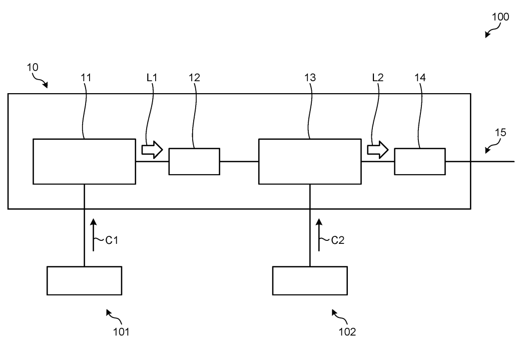




Processed by Luminess, 75001 PARIS (FR)

**Description**

Field

The present invention relates to a light source, a light source device, a method of driving a light source, a Raman amplifier, and a Raman amplification system.

Background

In conventional optical fiber communication, enhancement of a transmission distance and a transmission capacity have been achieved with use of an erbium-doped fiber amplifier (EDFA). However, in recent years, a technique for using not only the EDFA, but also Raman amplification, and effectively combining both of them is essential. Currently, backward-pumping Raman amplification that inputs pumping light such that the light propagates in a direction opposite to a direction of propagation of signal light with respect to an optical fiber for Raman amplification is mainly used as the Raman amplification. However, the key to further increase a speed (800 Gb/s), a distance (transmission of 1000 kilometers (km)), and a bandwidth (use of L-band and S-band) for next generation is to use a method called forward-pumping Raman amplification, which is a method of inputting pumping light such that the light propagates in the same direction as a direction of propagation of signal light with respect to an optical fiber for Raman amplification, simultaneously with the backward-pumping Raman amplification. This method is called as bi-directional pumping Raman amplification. Meanwhile, it is reported that, if a wavelength-multiplexing pumping method is used, it is possible to flatten a gain and increase a bandwidth even by only the backward-pumping Raman amplification, but it is difficult to achieve flattening of a noise figure (NF) without using the bi-directional pumping Raman amplification (Non Patent Literatures 13 and 14).

In forward pumping, a pumping light source with low relative intensity noise (RIN) is needed. The reason for this will be described below.

The RIN is an index that is obtained by standardizing a minute intensity fluctuation component of laser light by total optical power. In a phenomenon called the Raman amplification, a lifetime of an excited level at which a gain is generated is short (≈ several fsec), and therefore, if a pumping light source includes intensity noise, the intensity noise results in noise of signal light through an amplification process. In the EDFA, the lifetime of the excited level is long (≈ 10 msec), and therefore, the above-described risk is not present. In the Raman amplification, a gain per unit length is extremely small as compared to the EDFA; however, in the forward-pumping Raman amplification, signal light and pumping light propagates together in an optical fiber over a long distance, so that noise in the pumping light gradually transfers as noise of the signal light. This is called as RIN transfer. In the backward-pumping Raman amplification, the signal light and the pumping light are opposed to each other, so that a duration in which pumping light having a certain noise component and signal light cross each other is short, so that an influence of the noise in the pumping light on the signal light is small. Furthermore, the noise in the pumping light is random, and therefore, even if the signal light is affected, the influence is averaged while the light travels in the opposing direction. As can be seen from above, in the forward-pumping Raman amplification, a characteristic of low RIN transfer is needed, and reduction of the RIN transfer is particularly important in a dispersion shifted fiber (DSF), in which a group velocity difference between signal light and pumping light is small and a duration of parallel transfer in an optical fiber is increased (Non Patent Literatures 1, 3, and 4).

Citation List

Patent Literature

Patent Literature 1: U.S. Patent Application Publication No. 2014/0153083
Patent Literature 2: U.S. Patent No. 07190861
Patent Literature 3: U.S. Patent No. 07215836
Patent Literature 4: U.S. Patent No. 07236295
Patent Literature 5: U.S. Patent No. 07173757
Patent Literature 6: Japanese Patent No. 4069110
Patent Literature 7: U.S. Patent No. 10938175

Non Patent Literature

Non Patent Literature 1: PELOUCH, Wayne S. Raman amplification: An enabling technique for long-haul coherent transmission systems. Journal of Lightwave Technology, 2015, 34.1: 6-19.
Non Patent Literature 2: YAMAMOTO, Y.; MACHIDA, S.; NILSSON, O. Amplitude squeezing in a pump-noise-suppressed laser oscillator. Physical Review A, 1986, 34.5: 4025.
Non Patent Literature 3: KEITA, Kafing, et al. Relative intensity noise transfer of large-bandwidth pump lasers in Raman fiber amplifiers. JOSA B, 2006, 23.12: 2479-2485.
Non Patent Literature 4: FLUDGER, C. R. S.; HANDEREK, V.; MEARS, R. J. Pump to signal RIN transfer in Raman fiber amplifiers. Journal of Lightwave Technology, 2001, 19.8: 1140.
Non Patent Literature 5: VAKHSHOORI, D., et al. Raman amplification using high-power incoherent semiconductor pump sources. In: Optical Fiber Communication Conference. Optical Society of America, 2003. p. PD47.
Non Patent Literature 6: YAMATOYA, T.; KOYAMA, F.; IGA, K. Noise suppression and intensity modulation using gain-saturated semiconductor optical amplifier. In: Optical Amplifiers and Their Applications. Optical Society of America, 2000. p. OMD12.
Non Patent Literature 7: KOYAMA, F. High power superluminescent diodes for multi-wavelength light sources. In: Conference Proceedings. LEOS'97. 10th Annual Meeting IEEE Lasers and Electro-Optics Society 1997 Annual Meeting. IEEE, 1997. p. 333-334.
Non Patent Literature 8: ZHAO, Mingshan; MORTHIER, Geert; BAETS, Roel. Analysis and optimization of intensity noise reduction in spectrum-sliced WDM systems using a saturated semiconductor optical amplifier. IEEE Photonics Technology Letters, 2002, 14.3: 390-392.
Non Patent Literature 9: MORIMOTO, Masahito, et al. Co-propagating dual-order distributed Raman amplifier utilizing incoherent pumping. IEEE Photonics Technology Letters, 2017, 29.7: 567-570.
Non Patent Literature 10: MORIMOTO, Masahito, et al. Co-propagating distributed Raman amplifier utilizing incoherent pumping. In: Metro and Data Center Optical Networks and Short-Reach Links II. International Society for Optics and Photonics, 2019. p. 109460M.
Non Patent Literature 11: KOBAYASHI, Takayuki, et al. 2nd-order forward-pumped distributed Raman amplification employing SOA-based incoherent light source in PDM-16QAM WDM transmission system. IEICE Communications Express, 2019.
Non Patent Literature 12: KOBAYASHI, Takayuki, et al. PDM-16QAM WDM transmission with 2nd-order forward-pumped distributed Raman amplification utilizing incoherent pumping. In: Optical Fiber Communication Conference. Optical Society of America, 2019. p. Tu3F. 6.
Non Patent Literature 13: KADO, Soko, et al. Broadband flat-noise Raman amplifier using low-noise bidirectionally pumping sources. In: Proceedings 27th European Conference on Optical Communication (Cat. No. 01TH8551). IEEE, 2001. p. 38-39.
Non Patent Literature 14: EMORI, Yoshihiro; KADO, Soko; NAMIKI, Shu. Independent control of the gain and noise figure spectra of Raman amplifiers using bi-directional pumping. Furukawa Review, 2003, 23: 11-15.
Non Patent Literature 15: Fiber optic test and measurement/edited by Dennis Derickson. Upper Saddle River, 1998.

## Summary

### Technical Problem

The Raman amplification has lower excitation efficiency as compared to optical amplification using the EDFA, and therefore needs an pumping light source with high output power to fully obtain a gain. Therefore, a Fabry-Perot (FP) laser with output power of several hundred mW or more has been widely put into practical use; however, it is regarded that the FP-type laser is not suitable for forward pumping because the RIN transfer is large (Non Patent Literatures 3, 4, and 5).

In contrast, to suppress the RIN transfer, it is regarded that, as the pumping light source for the forward-pumping Raman amplification, use of amplified spontaneous emission (ASE) light that is incoherent light of a semiconductor optical amplifier (SOA) is effective (Patent Literatures 2 and 3 and Non Patent Literatures 3 and 5).

In future ultrafast and large-capacity transmission exceeding 800 Gbps, it is desirable that a Raman gain due to forward pumping is, for example, equal to or larger than 7 dB, and more preferably, equal to or larger than 10 dB in order to largely improve an optical signal to noise ratio (OSNR) of an entire system. Therefore, for example, a case in which high output power is achieved with a configuration in which continuously connected SOAs are subjected to polarization multiplexing and wavelength multiplexing has been reported (Non Patent Literature 5).

ASE light of an SOA with a small size and at a low cost is certainly a strong candidate; however, it is known that ripple occurs due to reflection of light at both facets of the SOA if high output power is to be achieved (Patent Literatures 4, 5, and 6).

According to Non Patent Literature 3, if incoherent light with a wide bandwidth is used for the forward-pumping Raman amplification, RIN transfer is suppressed due to an averaging effect. Here, Non Patent Literature 3 describes that, as a point that needs to be noted, a large number of longitudinal modes (in other words, ripple) due to Fabry-Perot oscillations need to be prevented from existing in order to achieve the averaging effect. Therefore, to take advantage of pumping of incoherent light in the forward-pumping Raman amplification, it is preferable to ensure high output power and suppress ripple in the incoherent light.

Here, in the SOA, ripple occurs because a Fabry-Perot resonator is formed between the both facets. Therefore, if reflectivity at the both facets is zero, ripple does not occur. However, it is practically impossible to reduce the reflectivity at the both facets of the SOA to zero. Therefore, the way to suppress the ripple is an important issue. Conventionally, (1) non-reflective coating, (2) an oblique waveguide structure, (3) a window structure, and the like have been used to suppress ripple. However, a preferable pumping light source for Raman amplification is high output power of several hundred mW or more, and therefore, even slight reflection may cause ripple to occur. Furthermore, a spectrum width of the ASE light is wide, such as about several dozen nm, but it is not easy to implement an anti-reflection treatment for low reflectivity over the wide spectrum width. In contrast, for example, Patent Literature 5 describes a method of moderating a requirement for reflectivity of a facet with non-reflective coating by arranging a mirror on a rear side of a rear facet of an SOA.

In contrast, it is known that, if a semiconductor laser is subjected to constant current drive in a certain driving current region that is fully larger than an oscillation threshold, in other words, in a saturated state, it is possible to suppress noise on a low frequency side (Non Patent Literature 2). Similarly, it is known that, in ASE light that is output from an SOA to which large incoherent light has been input and which is in a saturated state, RIN on the low frequency side is suppressed (Patent Literature 1 and Non Patent Literatures 6, 7, and 8).

Furthermore, according to Non Patent Literatures 3 and 4, RIN transfer is likely to occur on the low frequency side and cut on a high frequency side. In other words, a cutoff frequency is present in the RIN transfer. Therefore, a feature that the RIN on the low frequency side is suppressed in the ASE light of the SOA in the saturated state is extremely advantageous from the viewpoint of preventing degradation of transmission characteristics due to the RIN transfer.

FIG. 2 and FIG. 3 in Non Patent Literature 8 illustrate that RIN is further suppressed by increasing a driving current (a seed current or a booster current) in an SOA in a saturated state. However, if the driving current of the SOA is increased, not only optical power, but also ripple are increased. Furthermore, in an actual Raman amplification system, a Raman amplification gain is controlled by changing output power of a pumping light source. Therefore, there is a demand for a technique or a method capable of reducing ripple without affecting suppression of RIN even when optical power of the SOA is changed.

In summary, as an incoherent pumping light source for Raman amplification, ASE light of an SOA is a strong candidate from the viewpoint of reducing a size and a cost, but it is desirable to simultaneously solve conflicting problems as described below.

(1) High output power
(2) Suppression of ripple caused by reflection at facets of an SOA in a wide operation range and an output range of a pumping light source
(3) Suppression of RIN in the wide operation range and the output range of a pumping light source
(4) low power consumption

As a method of simultaneously solving the problems as described above, a method of performing secondary amplification on ASE light of an SOA with relatively low output power by using a Raman amplification FP-type pumping laser has been proposed (Patent Literature 7 and Non Patent Literatures 9, 10, 11, and 12). This method is an effective means in a long-distance and large-capacity Raman amplification transmission system that needs higher gain. However, in a relatively short-distance system, such as a metro transmission system, direct pumping using ASE light of an SOA that does not need secondary excitation is desired from the view point of simplification of the system, reduction of cost, and reduction of power consumption.

The present invention has been conceived in view of the foregoing situation, and an object of the present invention is to provide a light source, a light source device, and a method of driving a light source that are able to simultaneously suppress RIN and ripple, and to provide a Raman amplifier and a Raman amplification system using the light source, the light source device, and the light source driving method.

Solution to Problem

To solve the above-described problem and achieve the object, a light source according to one aspect of the present invention includes: a seed light source configured to output incoherent seed light with a predetermined bandwidth; and a booster amplifier that is a semiconductor optical amplifier configured to optically amplify the seed light input from a first facet, and output the amplified seed light as amplified light from a second facet, wherein the first facet and the second facet of the booster amplifier are subjected to a reflection reduction treatment, the booster amplifier is configured to operate in a gain saturated state, and relative intensity noise (RIN) and ripple are simultaneously suppressed in the amplified light.

A light source according to one aspect of the present invention includes: a seed light source configured to output incoherent seed light with a predetermined bandwidth; and a booster amplifier that is a semiconductor optical amplifier configured to optically amplify the seed light input from a first facet, and output the amplified seed light as amplified light from a second facet, wherein the seed light source and the booster amplifier are driven with a driving current with which relative intensity noise (RIN) and ripple are simultaneously suppressed in the amplified light.

The booster amplifier may be driven so as to operate in a gain saturated state.

The seed light source may be driven with a driving current that allows to output the seed light of certain power such that power of the amplified light approaches a maximum value.

The seed light source may be driven with a driving current that is reduced by five times or more as compared to a driving current with which a magnitude of ripple in the amplified light is minimized.

The seed light may be one of spontaneous emission light (SE) and amplified spontaneous emission light (ASE).

The seed light source may include at least one of a super luminescent diode (SLD), a semiconductor optical amplifier, and an amplified spontaneous emission light source including an optical fiber that is doped with rare earth.

Power of the amplified light that is output by the booster amplifier may be 100 mW or more.

Facet reflectivity of the first facet of the booster amplifier and facet reflectivity of the second facet of the booster amplifier may fall in a range between $10^{-3}$ and $10^{-5}$.

A light source device according to one aspect of the present invention includes: the light source; and a driving device configured to drive the light source.

A method of driving a light source according to one aspect of the present invention including a seed light source configured to output incoherent seed light with a predetermined bandwidth, and a booster amplifier that is a semiconductor optical amplifier configured to optically amplify the seed light input from a first facet, and output the amplified seed light as amplified light from a second facet includes: driving the seed light source and the optical amplifier with a driving current with which relative intensity noise (RIN) and ripple are simultaneously suppressed in the amplified light.

A Raman amplifier according to one aspect of the present invention includes: the light source; and a Raman optical amplification fiber configured to receive input of the amplified light as pumping light.

A Raman amplification system according to one aspect of the present invention includes: the light source; and a Raman optical amplification fiber configured to receive input of the amplified light as pumping light. Advantageous Effects of Invention

According to the present invention, it is possible to provide a light source, a light source device, and a method of driving a light source that are able to simultaneously suppress RIN and ripple, and to provide a Raman amplifier and a Raman amplification system using the light source, the light source device, and the light source driving method.

## Brief Description of Drawings

FIG. 1 is a diagram illustrating a light source device according to a first embodiment.
FIG. 2 is a diagram illustrating a part of a light source module illustrated in FIG. 1.
FIG. 3 is a diagram illustrating an example of a power spectrum of output light of a booster amplifier.
FIG. 4 is a diagram illustrating an example of power (Pf) of output light with respect to Ib.
FIG. 5 is a diagram illustrating an example of a RIN spectrum of output light.
FIG. 6 is a diagram schematically illustrating a spectrum in which RIN is suppressed.
FIG. 7 is a diagram illustrating another example of the power (Pf) of the output light with respect to Ib.
FIG. 8 is a diagram illustrating another example of the RIN spectrum of the output light.
FIG. 9 is a diagram illustrating another example of the RIN spectrum of the output light when Is is fixed and Ib is changed.
FIG. 10 is a diagram illustrating another example of the RIN spectrum of the output light when Ib is fixed and Is is changed.
FIG. 11 is a diagram illustrating still another example of the RIN spectrum of the output light when Ib is fixed and Is is changed.
FIG. 12 is a diagram illustrating an example of the power spectrum of the output light when Is is changed.
FIG. 13 is an enlarged diagram of the power spectrum in FIG. 12 in a range of wavelengths 1510 nm to 1512 nm.
FIG. 14 is a diagram illustrating an example of the power spectrum of the output light when Is is set to 0 mA and Ib is changed.
FIG. 15 is a diagram illustrating an example of ripple with respect to Is.

FIG. 16 is a diagram illustrating an example of the power (Pf) of the output light with respect to Is when Ib is changed.

FIG. 17 is a schematic diagram of a Raman amplifier according to a second embodiment.

FIG. 18 is a schematic diagram of a Raman amplification system according to a third embodiment. Description of Embodiments

Embodiments of the present invention will be described below with reference to the drawings. The present invention is not limited by the embodiments described below. In addition, in the description of the drawings, the same components are appropriately denoted by the same reference symbols, and repeated explanation will be appropriately omitted.

First Embodiment

FIG. 1 is a schematic diagram illustrating a light source device according to a first embodiment. A light source device 100 includes a light source module 10 and driving devices 101 and 102. The light source module 10 is one example of a light source.

The light source module 10 includes a seed light source 11 that is an SOA, an optical isolator 12, a booster amplifier 13 that is an SOA, an optical isolator 14, and an output optical fiber 15. The seed light source 11, the optical isolator 12, the booster amplifier 13, and the optical isolator 14 are optically continuously connected to one another in this order by an optical fiber, an optical element, or the like.

The seed light source 11 outputs incoherent seed light L1 with a predetermined bandwidth. The incoherent light means light as a set of uncorrelated photons with a continuous spectrum, rather than a laser light source that oscillates in a single or a plurality of discrete modes (longitudinal modes). The predetermined bandwidth is not specifically limited, but, for example, a wide bandwidth, such as a wavelength bandwidth of 25 nm or more, is preferable. The optical isolator 12 transmits the seed light L1, allows the seed light L1 to enter the booster amplifier 13, and prevents return light traveling from the booster amplifier 13 side from entering the seed light source 11. The optical isolator 12 prevents or reduces instability of operation of the seed light source 11 due to input of the return light.

The booster amplifier 13 optically amplifies the input seed light L1 and outputs amplified light L2. The optical isolator 14 transmits the amplified light L2, allows the amplified light L2 to enter the output optical fiber 15, and prevents light traveling from the output optical fiber 15 side from entering the booster amplifier 13. The optical isolator 14 prevents or reduces instability of operation of the booster amplifier 13 due to input of the return light.

The output optical fiber 15 is an optical fiber that guides the amplified light L2 to outside of the light source module 10. The amplified light L2 is used as, for example, pumping light for Raman amplification.

The driving devices 101 and 102 are well-known driving devices for SOAs. The driving device 101 supplies a driving current C1 to the seed light source 11. The driving device 102 supplies a driving current C2 to the booster amplifier 13.

FIG. 2 is a diagram illustrating a part of the light source module 10 illustrated in FIG. 1. The booster amplifier 13 includes a first facet 13a and a second facet 13b that face each other. The booster amplifier 13 receives input of the seed light L1 from the first facet 13a and outputs the amplified light L2 to the outside from the second facet 13b.

The first facet 13a and the second facet 13b are subjected to a reflection reduction treatment, such as anti-reflection (AR) coating. Further, the first facet 13a and the second facet 13b may be subjected to the reflection reduction treatment by being inclined with respect to an optical axis of an optical amplification waveguide that is included in the booster amplifier 13. This structure may also be referred to as an oblique waveguide structure.

Assuming that facet reflectivity of the first facet 13a is denoted by R1 and facet reflectivity of the second facet 13b is denoted by R2, R1 and R2 fall in a range between, for example, $10^{-3}$ and $10^{-5}$. Alternatively, $(R1\times R2)^{1/2}$ falls in the range between, for example, $10^{-3}$ and $10^{-5}$. A value in the range between $10^{-3}$ and $10^{-5}$ is one example of a numeric range that is fully practical and implementable in terms of low reflectivity. Here, the range between $10^{-3}$ and $10^{-5}$ is a range that includes $10^{-3}$ that is an upper limit and $10^{-5}$ that is a lower limit.

Characteristics of light source module 10

Characteristics of the light source module 10 will be described. FIG. 3 is a diagram illustrating an example of a power spectrum of the output light (amplified light) of the the booster amplifier. FIG. 3 illustrates a case in which Is is set to 50 mA and Ib is set to 800 mA, where Is is the driving current C1 that is supplied to the seed light source 11 and Ib is the driving current C2 that is supplied to the booster amplifier 13. The power spectrum of the output light in FIG. 3 has a substantially Gaussian spectrum shape, and a full width half maximum (FWHM) is about 25 nm to 30 nm.

FIG. 4 is a diagram illustrating an example of power (Pf) of the output light (amplified light) from the booster amplifier with respect to Ib. In FIG. 4, Is is set to 50 mA. In the case of FIG. 4, it can be seen that Pf is about 20 mW when Ib is 100 mA, and Pf is about 120 mW when Ib is 800 mA. Meanwhile, FIG. 3 and FIG. 4 illustrate examples of light source modules that are manufactured by using semiconductor optical amplifiers with substantially the same characteristics, as the seed light source and the booster amplifier.

Here, the present inventors have found that it is possible to realize a state in which RIN and ripple are simultaneously suppressed in the light source module 10 as illustrated in FIG. 1. In the following, suppression of RIN will be first described, and thereafter, suppression of ripple will be described.

Suppression of RIN

FIG. 5 is a diagram illustrating an example of a RIN spectrum of output light. Specifically, FIG. 5 illustrates measurement results of RIN of output light coming from light source modules No. 1 to No. 3 that are manufactured as examples of the light source module 10. Meanwhile, the light source modules No. 1 to 3 are manufactured using semiconductor optical amplifiers with substantially the same characteristics, as the seed light source and the booster amplifier, and have the same output characteristics as the characteristics illustrated in FIG. 3 and FIG. 4. Further, it was confirmed that, in the light source modules No. 1 to No. 3, facet reflectivity is set such that $(R1 \times R2)^{1/2}$ falls in the range between $10^{-3}$ and $10^{-5}$. Furthermore, in FIG. 5, Ts represents case temperature (25°C) of the seed light source, and Tb represents case temperature (25°C) of the booster amplifier.

In FIG. 5, "only Ib" indicates a case in which a driving current of 100 mA is supplied to only the booster amplifier and a driving current is not supplied to the seed light source (in other words, a supplied driving current is 0 mA). In this case, a seed light source that needs to be amplified is not input to the booster amplifier, and therefore, the booster amplifier functions as a simple ASE light source. In contrast, "Is+Ib" indicates a case in which a driving current of 100 mA is supplied to the booster amplifier and a driving current of 200 mA is supplied to the seed light source.

As can be seen from FIG. 5, in the case of "only Ib", a relatively flat RIN spectrum with respect to a frequency was obtained in each of the light source modules No. 1 to No. 3. It is assumed that the RIN is caused by beat noise between ASEs in output light (ASE light) that is output from the booster amplifier serving as the ASE light source.

In contrast, in the case of "Is+Ib", it can be seen that RIN is suppressed on a low frequency side from a specific frequency fc in each of the light source modules No. 1 to No. 3. Meanwhile, in the case of "Is+Ib", seed light (ASE light) that is output from the seed light source is input to the booster amplifier and the number of internal photons is increased, so that it is assumed that the booster amplifier is operating in a gain saturated state. Here, a matter that needs to be paid attention to is that, in FIG. 5, even in a driving state in which Ib is a relatively low electric current, such as 100 mA, and power of the output light from the booster amplifier is relatively small, a RIN suppressed state is already achieved. This will be described in detail later.

FIG. 6 is a diagram schematically illustrating a spectrum in which the RIN is suppressed.

Here, the output light that is output from the light source, such as the light source module, of the embodiment is the ASE light of the SOA, and therefore, the RIN is determined by a magnitude of a beat noise between the ASEs. In FIG. 6, a level indicated by a line 210 is a level of the beat noise between the ASEs.

A power spectral width of ASE light of a normal SOA is several dozen nm, and is several THz if represented by a frequency. A measurement bandwidth of the RIN is fully small, such as several dozen GHz, so that the RIN can be calculated by Expression (1) below (Non Patent Literature 15).

$$RIN = 0.66/\Delta\nu_{ASE}\ [Hz^{-1}] \qquad (1)$$

Here, 0.66 is a coefficient for the case where the power spectrum of the ASE light is the Gaussian type, and $\Delta\nu_{ASE}$ is a FWHM of the power spectrum.

For example, the power spectrum of the output light illustrated in FIG. 3 is the Gaussian type and the FWHM is about 30 nm, and therefore, RIN is calculated as about -127 dB/Hz by Expression (1) above. This value approximately matches the result illustrated in FIG. 5.

In contrast, RIN of an SOA that operates in the gain saturated state is suppressed in a low frequency region 211 that is lower than fc that is also referred to as a corner frequency 213. For example, it is reported that the RIN is suppressed by about 10 dB to 20 dB from the level indicated by the line 210 (Patent Literature 1 and Non Patent Literatures 6 and 8). Meanwhile, a line 212 indicates a level of shot noise.

In the present specification, suppression of the RIN means suppression by 10 dB or more relative to the RIN that is calculated by Expression (1) above. A degree of suppression of the RIN may be 16 dB or less, or may be 20 dB or less.

FIG. 7 is a diagram illustrating another example of the power (Pf) of the output light (amplified light) with respect to Ib, and FIG. 8 is a diagram illustrating another example of the RIN spectrum of the output light. Specifically, FIG. 7 illustrates the power (Pf) of the output light (amplified light) from the booster amplifier with respect to Ib, for each of light source modules No. 4 to No. 7 that are manufactured as examples of the light source module 10. In FIG. 7, Is is set to 50 mA. In the case of FIG. 7, Pf is about 20 mW when Ib is 100 mA, Pf is about 140 to 150 mW when Ib is 800 mA, and it can be seen that the light source modules No. 4 to No. 7 have output characteristics similar to the light source modules No. 1 to No. 3. Further, in FIG. 8, Ts represents case temperature (25°C) of the seed light source, and Tb represents case temperature (25°C) of the booster amplifier. Furthermore, Is is 50 mA and Ib is 400 mA.

As illustrated in FIG. 8, it can be seen that the RIN is suppressed on a low frequency side from the specific frequency fc in each of the light source modules No. 4 to No. 7. Here, a matter that needs to be paid attention to is that, in FIG. 8, even in a driving state in which Ib is increased to 400 mA and the power of the output light from the booster amplifiers is increased as compared to the case of FIG. 5, the RIN suppressed state is already achieved.

From the results of the light source modules No. 1 to No. 7 with similar characteristics as described above, it can be considered that the RIN suppressed state can be equally achieved in a wide range in which the driving power and the output light are increased by about four times such that at least Ib is changed from about 100 to about 400 mA and the output light is changed from about 20 mW to about 90 mW. However, the ranges of Ib and the output light are not limited to the above-described examples, and any range is satisfactory as long as the RIN suppressed state can be achieved. For example, as for the power of the output light of the booster amplifier, 100 mW or more is preferable as a pumping light source for Raman amplification.

Subsequently, RIN is measured for a light source module No. 8 that is manufactured as an example of the light source module 10. The light source module No. 8 has output characteristics similar to the light source modules No. 1 to No. 7.

FIG. 9 is a diagram illustrating another example of the RIN spectrum of the output light when Is is fixed and Ib is changed, and is a diagram illustrating a result with respect to the light source module No. 8. Meanwhile, in FIG. 9 to FIG. 12, "ASE-ASE beat noise" indicates a level of beat noise between ASEs, which is calculated by Expression (1). In FIG. 9, Is is fixed to 0 mA and Ib is changed to 100, 200, 500, and 1000 mA. In the case of FIG. 9, Is is 0 mA, and therefore, the booster amplifier functions as an ASE light source. In this case, RIN is slightly reduced with an increase in Ib, but is not much changed.

FIG. 10 is a diagram illustrating another example of the RIN spectrum of the output light when Ib is fixed and Is is changed, and is a diagram illustrating a result with respect to the light source module No. 8. In FIG. 10, Ib is fixed to 500 mA and Is is changed to 0, 20, 40, and 60 mA. Meanwhile, the seed light source has the output power of about 0.1 mW, about 0.2 mW, and about 1.4 mW when Is is changed to 0, 20, 40, and 60 mA, all of which are small. In the case of FIG. 10, RIN is drastically reduced to approximately -160 dB/Hz that is equal to or smaller than -150 dB/Hz if Is is set to 40 mA or more.

FIG. 11 is a diagram illustrating another example of the RIN spectrum of the output light when Ib is fixed and Is is changed, and is a diagram illustrating a result with respect to the light source module No. 8. In FIG. 11, Ib is fixed to 1000 mA and Is is changed to 0, 20, 40, and 60 mA. In the case of FIG. 10, RIN is drastically reduced to approximately -160 dB/Hz that is equal to or smaller than -150 dB/Hz if Is is set to 40 mA or more.

Thus, according to the embodiment and the examples as described above, it is possible to realize a light source in which Ib dependency of noise characteristics (RIN characteristics), i.e., dependency on output power from the booster amplifier, is low by setting Is to a certain degree at which it is at least possible to achieve the RIN suppressed state. As described above, in an actual Raman amplification system, a Raman amplification gain is controlled by changing output of a pumping light source; however, in the light source of the embodiment or the examples, dependency of RIN suppression characteristics on the output power of the booster amplifier is reduced, so that it is possible to provide characteristics that are extremely easy to use with respect to the Raman amplification system. In other words, the excellent characteristics that the RIN suppression characteristics are not much changed even if the Raman amplification gain is changed are provided.

Suppression of ripple

Suppression of ripple will be described below. Specifically, a power spectrum of output light from a light source module with output characteristics similar to the light source module No. 1 is measured while changing diving conditions for the seed light source and the booster amplifier.

FIG. 12 is a diagram illustrating an example of the power spectrum of the output light when Is is changed. FIG. 13 is an enlarged diagram of the power spectrum illustrated in FIG. 12 in a wavelength range from 1510 nm to 1512 nm. FIG. 14 is a diagram illustrating an example of the power spectrum of the output light when Is is set to 0 mA and Ib is changed.

First, FIG. 14 will be described. In FIG. 14, ripple occurs both when Ib is 200 mA and when Ib is 800 mA. In particular, if Ib is 200 mA, ripple occurs although power of the output light is relatively low, such as about 18 mW. Further, if Is is set to 0 mA, ripple is most likely to occur. As described above, the ripple is caused by reflection of light at both facets of an SOA; however, the ripple occurs although the facet reflectivity of the booster amplifier falls in a fully small range such that $(R1\times R2)^{1/2}$ falls in the range between $10^{-3}$ and $10^{-5}$. The occurrence of ripple even with a low driving current (low power) and low reflectivity is one example indicating that it is extremely difficult to suppress ripple in the pumping light source for Raman amplification in which optical power reaches several hundred mW in some cases. Meanwhile, the ripple contains components of a plurality of different periods.

In contrast, as illustrated in FIG. 12 and FIG. 13, if Ib is fixed to 800 mA and Is is increased to 25 mA, the ripple is suppressed, and is further suppressed if Is is 50 mA. However, if Is is further increased to 400 mA, ripple increases again. FIG. 15 is a diagram illustrating an example of ripple with respect to Is in the cases of FIG. 12 and FIG. 13. As illustrated in FIG. 15, if Is is 50 mA, magnitude of ripple is reduced to below 0.5 dB. Meanwhile, the magnitude of the ripple represents a maximum value of a ripple width (peak-to-bottom) that appears in the power spectrum at a predetermined wavelength (for example, around 1510 nm).

As illustrated in FIG. 12, FIG. 13, and FIG. 15, if the seed light is input to the booster amplifier, a gain saturated state is achieved and ripple is suppressed in a certain region. This indicates that ripple may be suppressed by controlling the power of the seed light that is input to the booster amplifier, without reducing the facet reflectivity of the booster amplifier to the extent that the ripple is suppressed. Meanwhile, the spectrum of the ASE light of the SOA is wide from several nm to several dozen nm, and it is not easy to perform a treatment (for example, anti-reflection treatment) for reducing the facet reflectivity so as to cover the wide bandwidth as described above. Therefore, the technique for suppressing ripple by controlling the power of the seed light is a technique that can alleviate difficulties in conditions for setting the facet reflectivity of the booster amplifier and manufacturing of the booster amplifier, which is an extremely effective technique in a practical sense.

As for the suppression of the ripple, it is preferable to reduce the ripple as much as possible; however, for example, it is preferable to reduce the ripple to 5 dB, to 3 dB or less, to 1 dB or less, or to 0.5 dB or less or less from peak to bottom.

Therefore, as a method of driving the light source module serving as the light source, it is preferable to drive the seed light source and the booster amplifier with driving currents (Is, Ib) with which RIN and ripple are simultaneously suppressed in amplified light.

Driving current of seed light source

Is that is the driving current of the seed light source will be described below. Is may be set to an appropriate range from the view point of, for example, suppression of RIN, power consumption, or power of output light.

FIG. 16 is a diagram illustrating an example of the power (Pf) of the output light with respect to Is when Ib is changed. Specifically, with respect to a light source module with output characteristics similar to the light source module No. 1, power of output light with respect to Is was measured by setting Ib to any of 200 mA, 400 mA, 600 mA, and 800 mA.

As illustrated in FIG. 16, at any Ib, Pf rapidly increases with an increase in Is, but an increase in Pf tends to be finally saturated. RIN and ripple are started to be suppressed in the same manner in a certain region of Is in which saturation of Pf is started. Here, a matter that needs to be paid attention to is that, as illustrated in FIG. 15, ripple increases if Is is excessively increased and, as illustrated in FIG. 16, Pf does not much increase in the region in which Pf is saturated even if Is is increased.

Therefore, for example, it is preferable to drive the seed light source with a driving current with which seed light of power by which the power (Pf) of the amplified light (the output light) approaches a maximum value. For example, an example in which Ib in FIG. 16 is set to 600 mA will be described. In this case, if Is is set to 400 mA, Pf is about 110 mW, which is approximately a maximum value. In contrast, as power that is close to 110 mW, Is of about 50 mW is needed to output the seed light with the power Pf of 100 mW that is about 90% of 110 mW.

In other words, Is of 400 mW is needed to realize Pf with a maximum value of 110 mW, but Is of 50 mW is satisfactory to realize Pf of 100 mW that is close to 110 mW. By selecting the driving state as described above, it is possible to largely reduce power consumption of the seed light source, and resultantly reduce power consumption of the light source. Meanwhile, in the present example, 100 mW that is about 90% of 110 mW as the maximum value is selected as the value close to the maximum value, but the degree of closeness may be set in accordance with the needed power of the output light, and may be set to a value in the range of 80% to 95% of the maximum value, for example.

Furthermore, the seed light source may be driven with the driving current (Is) that is reduced by five time or more as compared to a driving current with which a magnitude of ripple in the amplified light is minimized. With this configuration, driving is performed with Is that is not too large with respect to Is with which the magnitude of ripple is minimized, which is effective from the viewpoint of reduction of power consumption. For example, in FIG. 15, the magnitude of the ripple is minimized when Is is 50 mA, and therefore, Is is preferably set to 250 mA or less.

As described above, Is has an optimal range that simultaneously meets demands for suppression of RIN, suppression of ripple, and power of amplified light.

As described above, the light source device and the light source module according to the embodiment is suitable for a pumping light source for Raman amplification, in particular, a pumping light source for forward pumping, because RIN and ripple are simultaneously suppressed in amplified light, and is particularly excellent in terms of suppression of RIN and suppression of RIN transfer.

Second Embodiment

FIG. 17 is a schematic diagram illustrating a Raman amplifier according to a second embodiment. A Raman amplifier 1000 is configured as a discrete optical amplifier of a forward-pumping type that includes the light source module 10 of the first embodiment. The Raman amplifier 1000 includes a light source device 100 including the light source module 10, a signal light input unit 1001, an optical multiplexer 1002, a Raman optical amplification fiber 1003, such as a highly nonlinear optical fiber, and a Raman-amplified light output unit 1004.
The signal light input unit 1001 receives input of signal light L11. The optical multiplexer 1002 multiplexes the signal light L11 and the amplified light L2, which is output from the output optical fiber 15 of the light source module 10 and serves as pumping light, and allows the multiplexed light to enter the Raman optical amplification fiber 1003. The Raman optical amplification fiber 1003 performs Raman amplification on the signal light L11 by using the amplified light L2 as pumping light. The Raman-amplified light output unit 1004 outputs Raman amplified light L12 that is light obtained by performing Raman amplification on the signal light L11.
A wavelength of the amplified light L2 coming from the light source module 10 is set such that the Raman amplification can be performed on the signal light L11 in the Raman optical amplification fiber 1003.
The Raman amplifier 1000 is excellent particularly in terms of suppression of RIN and suppression of RIN transfer.

Third Embodiment

FIG. 18 is a schematic diagram illustrating a Raman amplification system according to a third embodiment. A Raman amplification system 2000 is configured as a distributed optical amplification system of a forward-pumping type that includes the light source module 10 of the first embodiment as a pumping light source. The Raman amplification system 2000 includes a light source device 200 including the light source module 10, a signal light input unit 2001, a Raman optical amplification fiber 2003, such as a dispersion shift fiber, and a Raman-amplified light output unit 2004.
The light source device 200 is configured by adding an optical multiplexer 201 to the light source device 100. Further, as the Raman optical amplification fiber 2003, an optical fiber for optical communication and installed in a field may be used, for example.
The signal light input unit 2001 receives input of signal light L21. The optical multiplexer 201 multiplexes the signal light L11 and the amplified light L2 the amplified light L2, which is output from the output optical fiber 15 of the light source module 10 and serves as pumping light, and allows the multiplexed light to enter the Raman optical amplification fiber 2003. The Raman optical amplification fiber 2003 performs Raman amplification on the signal light L21 by using the amplified light L2 as pumping light. The Raman-amplified light output unit 2004 outputs Raman amplified light L22 that is light obtained by performing Raman amplification on the signal light L21.
A wavelength of the amplified light L2 coming from the light source module 10 is set such that the Raman amplification can be performed on the signal light L21 in the Raman optical amplification fiber 2003.
The Raman amplification system 2000 is excellent particularly in terms of suppression of RIN and suppression of RIN transfer.
The Raman amplifier and the Raman amplification system of the embodiments as described above are configured as the forward-pumping types, but embodiments of the present invention are not limited to these examples, and may be configured as backward-pumping types or bi-direction pumping types.
Furthermore, the light source module and the light source device of the embodiments as described above are not limited to pumping light sources for Raman amplification, but may be widely used as light sources in which RIN and ripple are simultaneously suppressed.
Moreover, in the embodiments as described above, the seed light is the ASE light, but may be incoherent light, such as spontaneous emission light.
Furthermore, in the embodiments as described above, the seed light source is the semiconductor optical amplifier, but may include at least one of a super luminescent diode (SLD), an SOA, and an ASE light source including an optical fiber doped with rare earth. The SLD, the SOA, and the ASE light source as described above are preferable as incoherent light sources.
Moreover, the present invention is not limited by the embodiments as described above. The present invention includes a configuration that is obtained by appropriately combining the components as described above. In addition, additional effects and modifications will readily occur by a person skilled in the hart. Therefore, in broader aspects of the present invention, the present invention is not limited by the embodiments as described above, and various modifications may be made.

Reference Signs List

10 light source module
11 seed light source
12, 14 optical isolator
13 booster amplifier
13a first facet
13b second facet
15 output optical fiber
100, 200 light source device
101, 102 driving device
1000 Raman amplifier
1001, 2001 signal light input unit
1002, 201 optical multiplexer
1003, 2003 Raman optical amplification fiber
1004, 2004 Raman-amplified light output unit
2000 Raman amplification system
C1, C2 driving current
L1 seed light
L11, L21 signal light
L12, L22 Raman amplified light
L2 amplified light

## Claims

1. A light source comprising:

   a seed light source configured to output incoherent seed light with a predetermined bandwidth; and
   a booster amplifier that is a semiconductor optical amplifier configured to optically amplify the seed light input from a first facet, and output the amplified seed light as amplified light from a second facet, wherein
   the first facet and the second facet of the booster amplifier are subjected to a reflection reduction treatment,
   the booster amplifier is configured to operate in a gain saturated state, and
   relative intensity noise (RIN) and ripple are simultaneously suppressed in the amplified light.

2. A light source comprising:

   a seed light source configured to output incoherent seed light with a predetermined bandwidth; and
   a booster amplifier that is a semiconductor optical amplifier configured to optically amplify the seed light input from a first facet, and output the amplified seed light as amplified light from a second facet, wherein
   the seed light source and the booster amplifier are driven with a driving current with which relative intensity noise (RIN) and ripple are simultaneously suppressed in the amplified light.

3. The light source according to claim 2, wherein the booster amplifier is driven so as to operate in a gain saturated state.

4. The light source according to claim 2 or 3, wherein the seed light source is driven with a driving current that allows to output the seed light of certain power such that power of the amplified light approaches a maximum value.

5. The light source according to any one of claims 2 to 4, wherein the seed light source is driven with a driving current that is reduced by five times or more as compared to a driving current with which a magnitude of ripple in the amplified light is minimized.

6. The light source according to any one of claims 1 to 5, wherein the seed light is one of spontaneous emission light (SE) and amplified spontaneous emission light (ASE).

7. The light source according to any one of claims 1 to 6, wherein the seed light source includes at least one of a super luminescent diode (SLD), a semiconductor optical amplifier, and an amplified spontaneous emission light source including an optical fiber that is doped with rare earth.

**8.** The light source according to any one of claims 1 to 7, wherein power of the amplified light that is output by the booster amplifier is 100 mW or more.

**9.** The light source according to any one of claims 1 to 8, wherein facet reflectivity of the first facet of the booster amplifier and facet reflectivity of the second facet of the booster amplifier fall in a range between $10^{-3}$ and $10^{-5}$.

**10.** A light source device comprising:

the light source according to any one of claims 1 to 9; and
a driving device configured to drive the light source.

**11.** A method of driving a light source including a seed light source configured to output incoherent seed light with a predetermined bandwidth, and a booster amplifier that is a semiconductor optical amplifier configured to optically amplify the seed light input from a first facet, and output the amplified seed light as amplified light from a second facet, the method comprising:
driving the seed light source and the optical amplifier with a driving current with which relative intensity noise (RIN) and ripple are simultaneously suppressed in the amplified light.

**12.** A Raman amplifier comprising:

the light source according to any one of claims 1 to 9; and
a Raman optical amplification fiber configured to receive input of the amplified light as pumping light.

**13.** A Raman amplification system comprising:

the light source according to any one of claims 1 to 9; and
a Raman optical amplification fiber configured to receive input of the amplified light as pumping light.

FIG.1

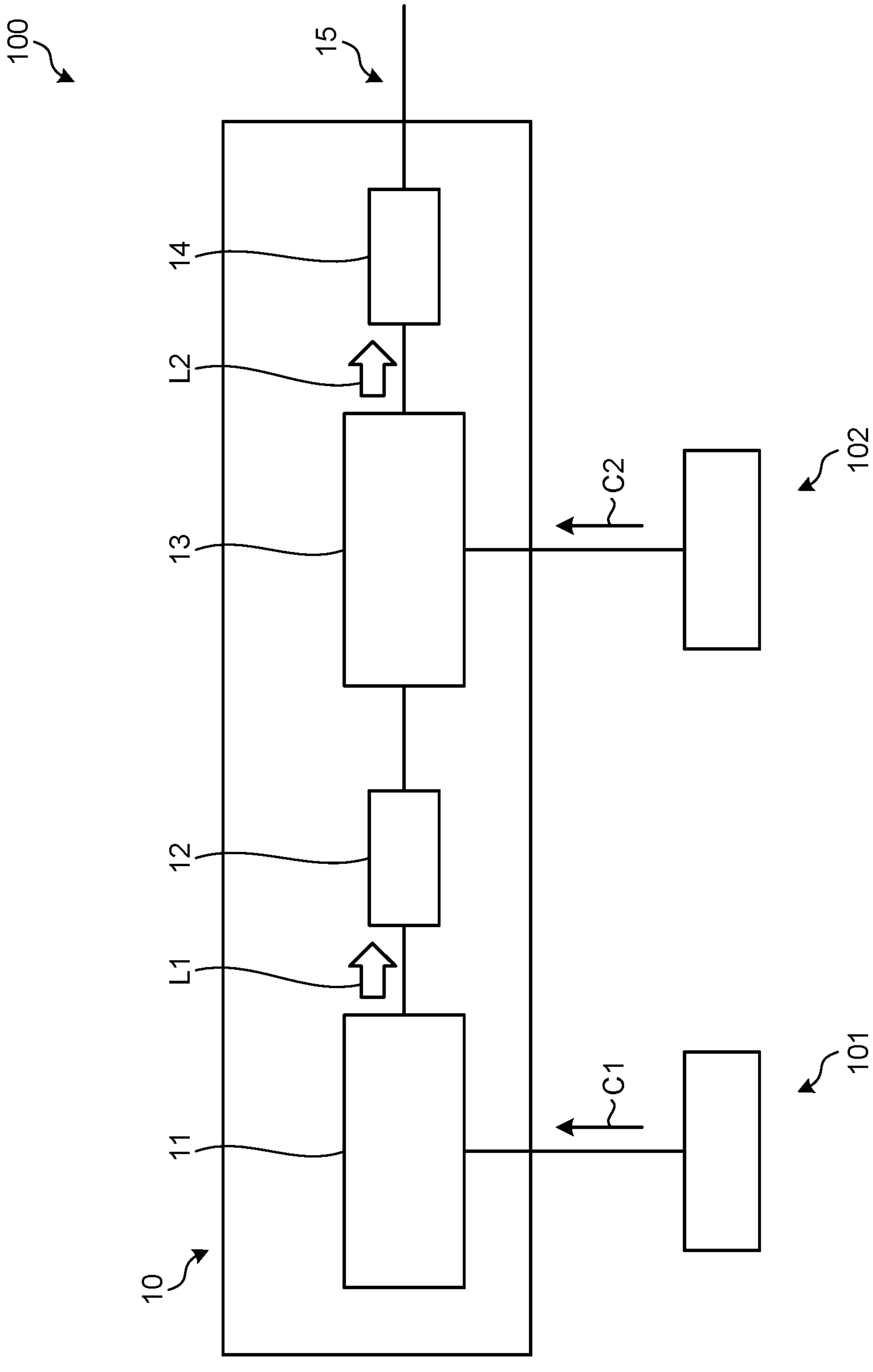

FIG.2

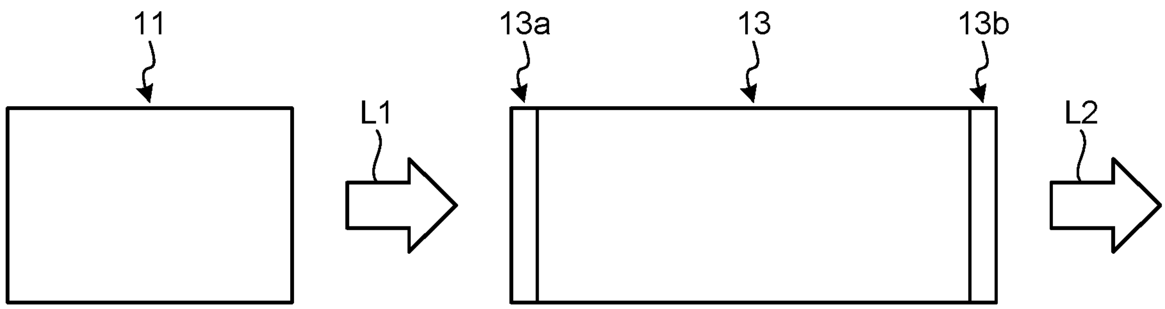
11
13a
13
13b
L1
L2

FIG.3

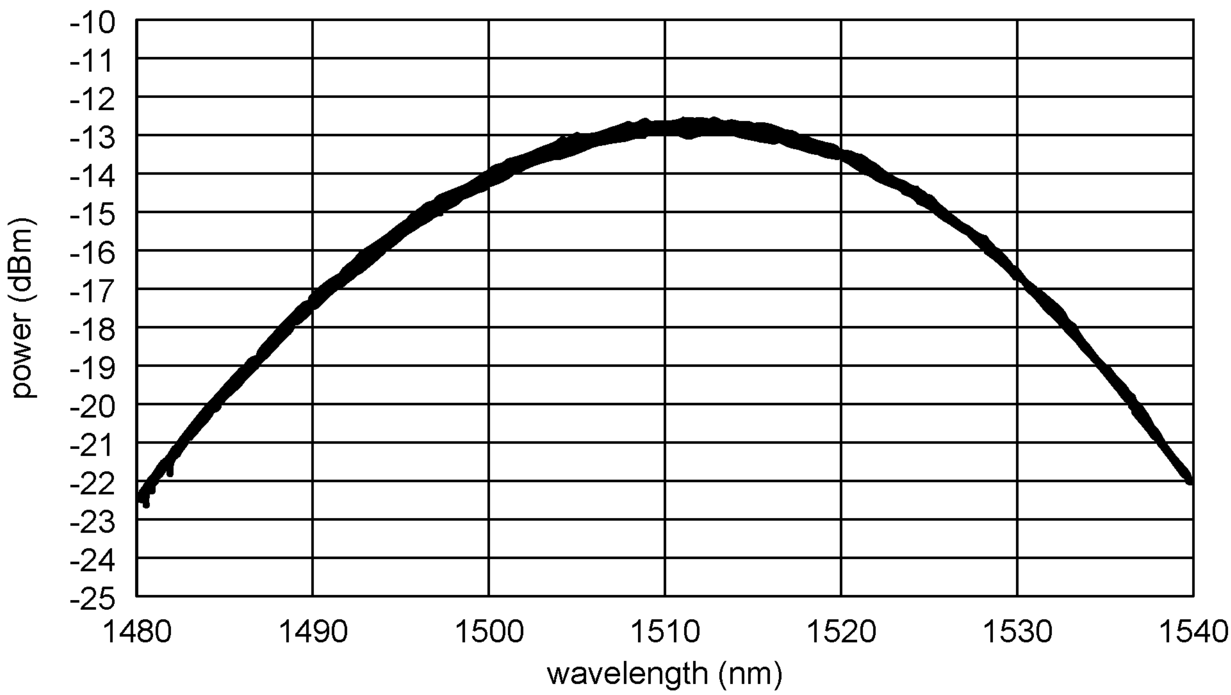
power (dBm)
-10
-11
-12
-13
-14
-15
-16
-17
-18
-19
-20
-21
-22
-23
-24
-25
1480
1490
1500
1510
1520
1530
1540
wavelength (nm)

# FIG.4

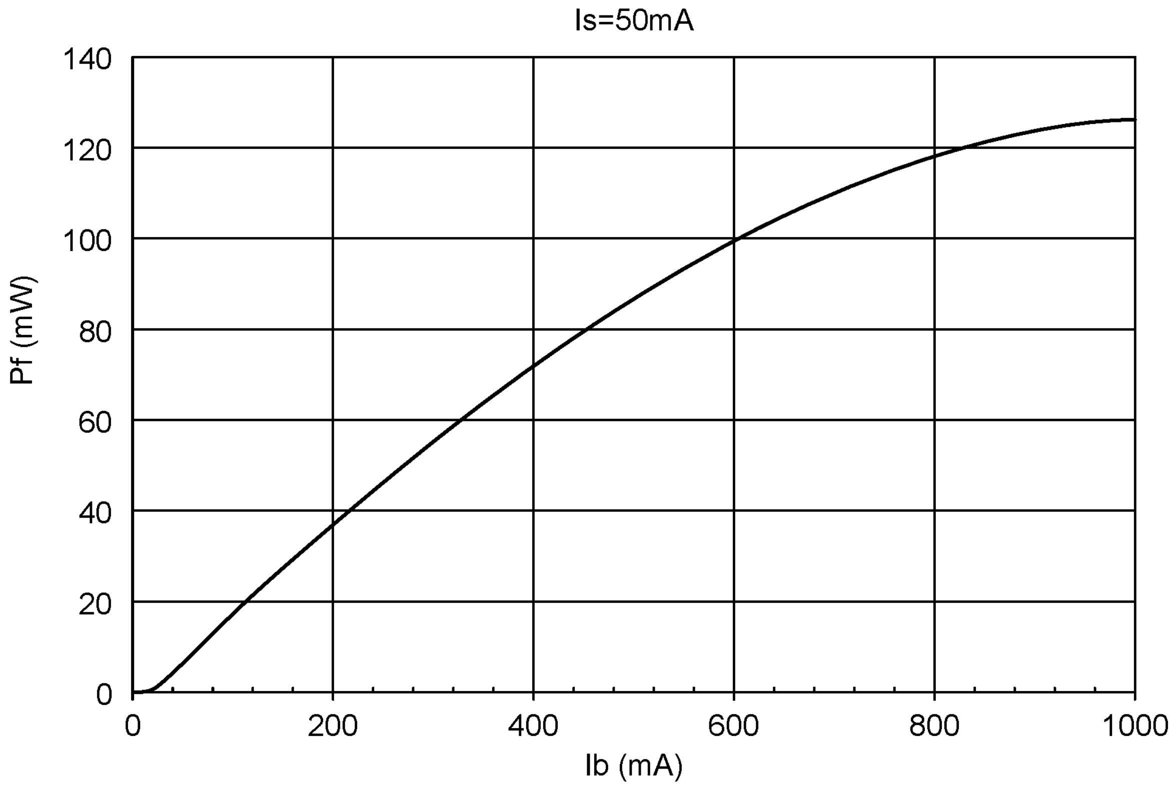
Is=50mA
140
120
100
80
60
40
20
0
Pf (mW)
0
200
400
600
800
1000
Ib (mA)

# FIG.5

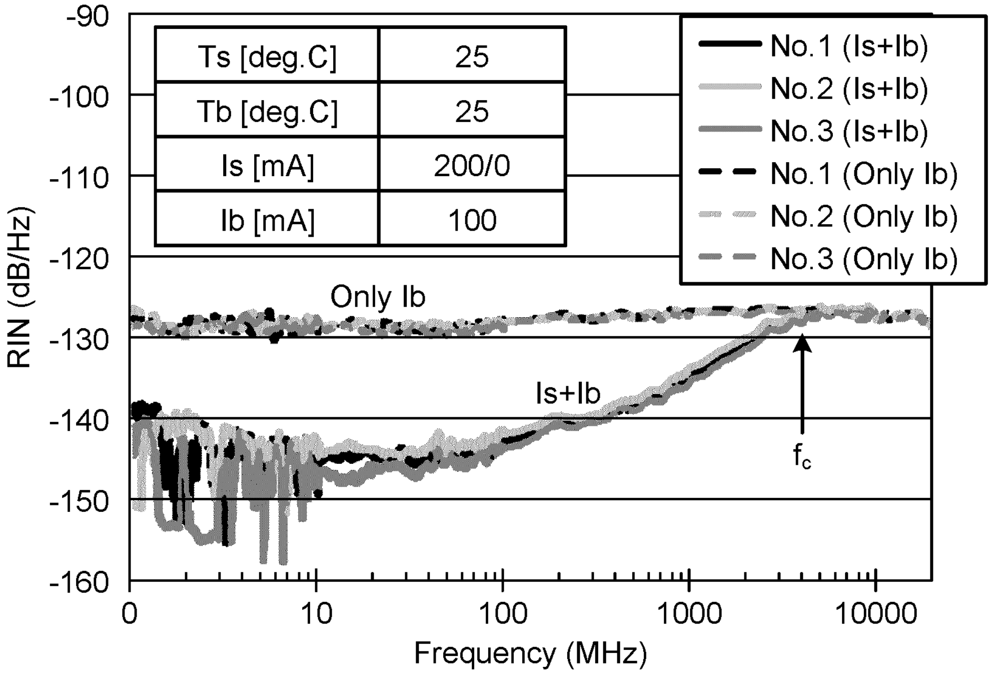
-90
-100
-110
-120
-130
-140
-150
-160
RIN (dB/Hz)
Ts [deg.C] 25
Tb [deg.C] 25
Is [mA] 200/0
Ib [mA] 100
No.1 (Is+Ib)
No.2 (Is+Ib)
No.3 (Is+Ib)
No.1 (Only Ib)
No.2 (Only Ib)
No.3 (Only Ib)
Only Ib
Is+Ib
$f_c$
0
10
100
1000
10000
Frequency (MHz)

FIG.6

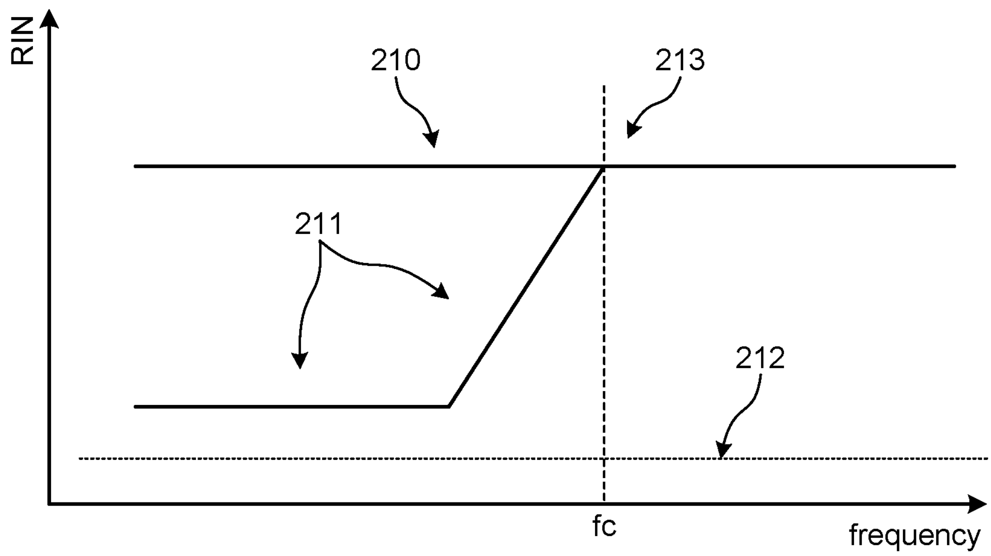
RIN
210
213
211
212
fc
frequency

FIG.7

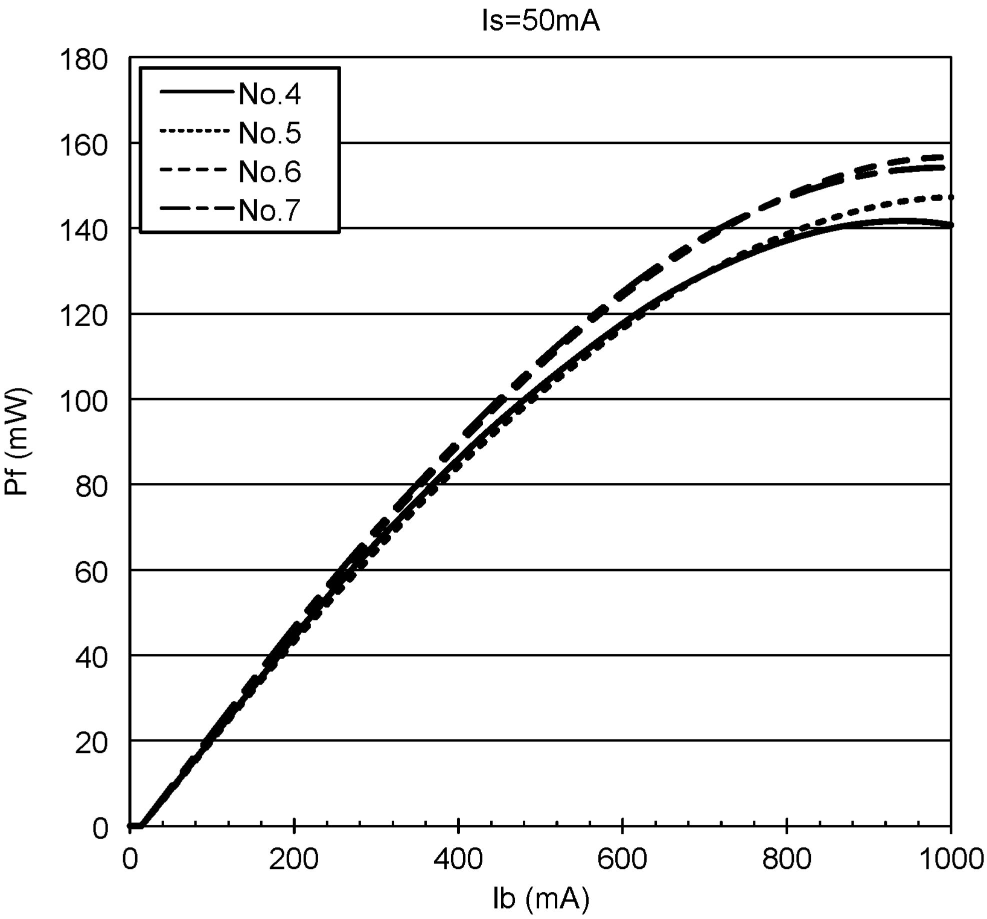
Is=50mA
No.4
No.5
No.6
No.7
Pf (mW)
0
20
40
60
80
100
120
140
160
180
0
200
400
600
800
1000
Ib (mA)

FIG.8

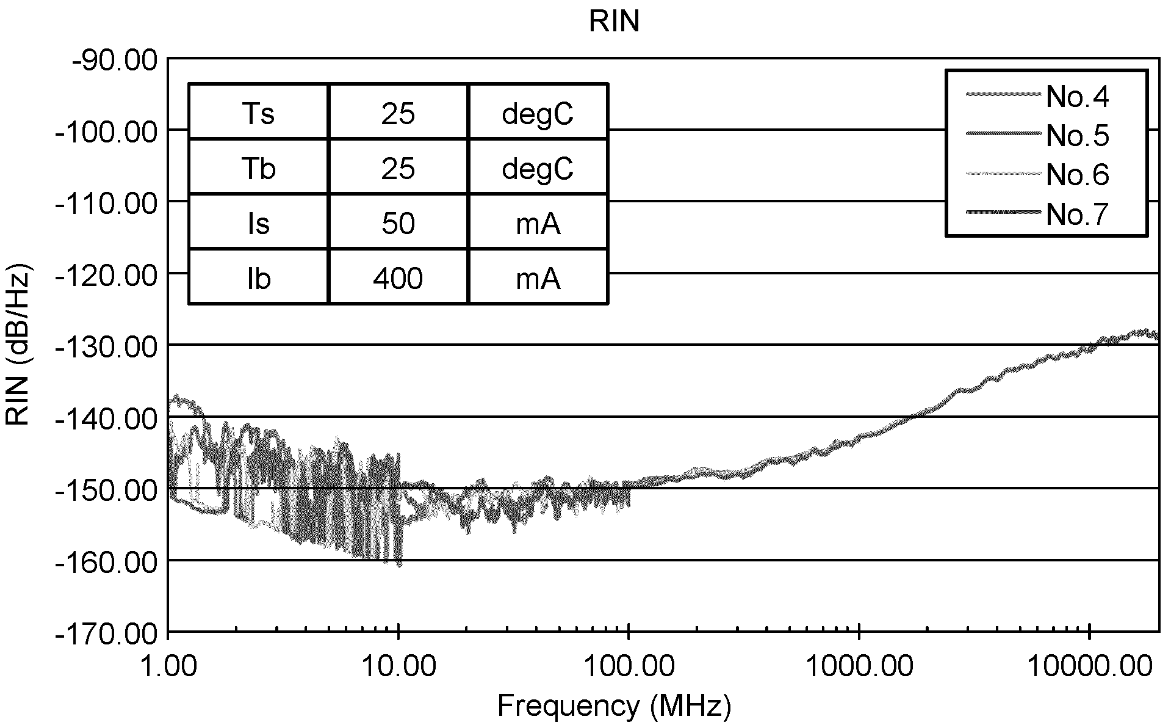
RIN
RIN (dB/Hz)
-90.00
-100.00
-110.00
-120.00
-130.00
-140.00
-150.00
-160.00
-170.00
Ts 25 degC
Tb 25 degC
Is 50 mA
Ib 400 mA
No.4
No.5
No.6
No.7
1.00
10.00
100.00
1000.00
10000.00
Frequency (MHz)

FIG.9

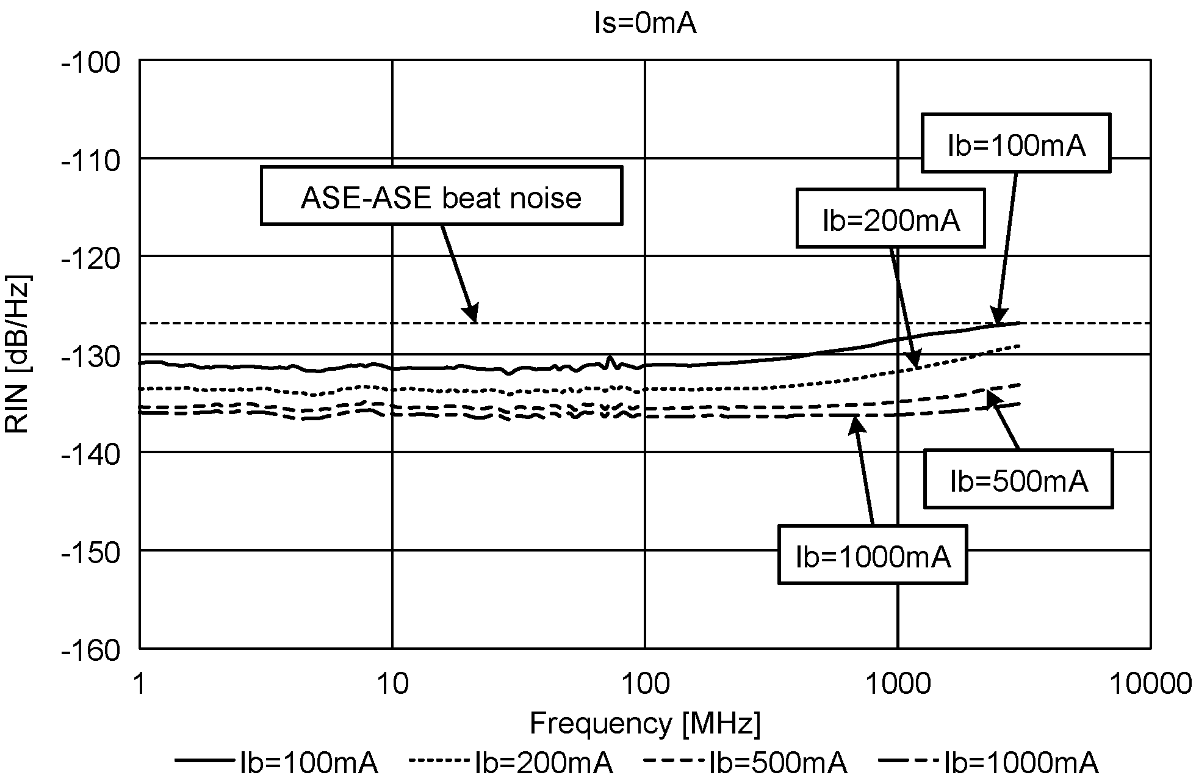
Is=0mA
RIN [dB/Hz]
-100
-110
-120
-130
-140
-150
-160
ASE-ASE beat noise
Ib=100mA
Ib=200mA
Ib=500mA
Ib=1000mA
1
10
100
1000
10000
Frequency [MHz]
Ib=100mA Ib=200mA Ib=500mA Ib=1000mA

FIG.10

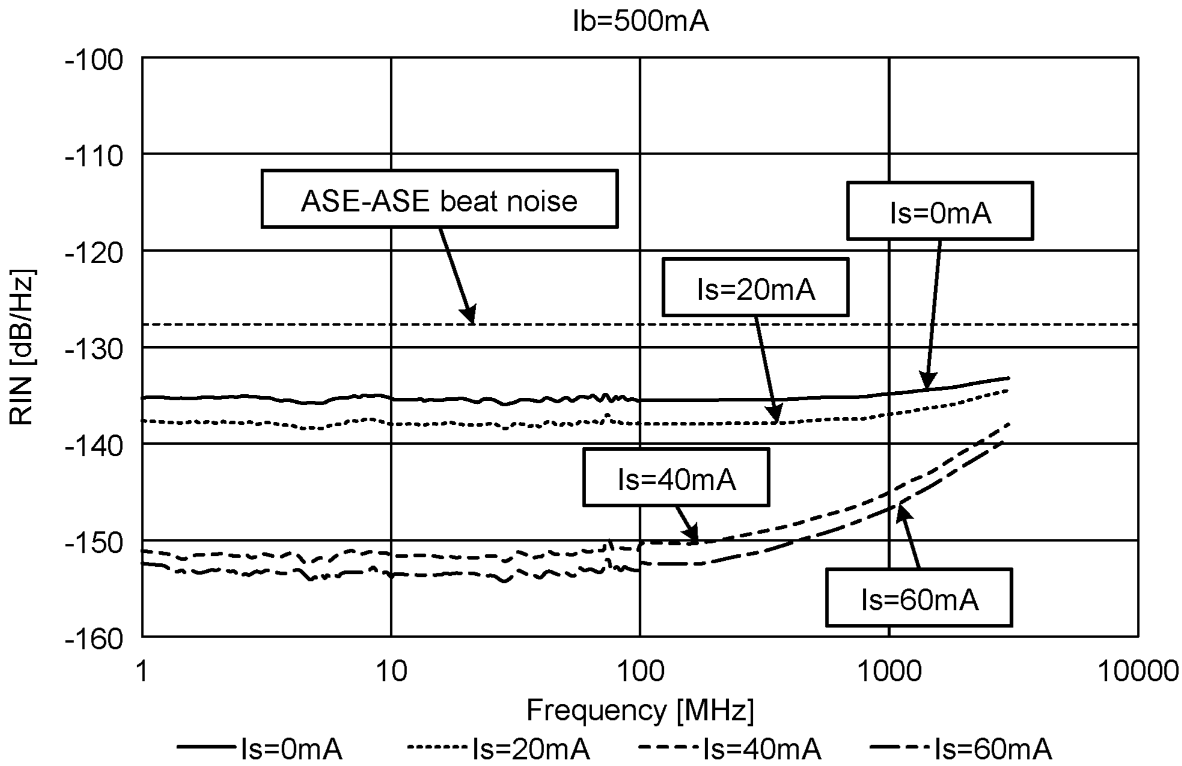
Ib=500mA
-100
-110
-120
-130
-140
-150
-160
RIN [dB/Hz]
ASE-ASE beat noise
Is=0mA
Is=20mA
Is=40mA
Is=60mA
1
10
100
1000
10000
Frequency [MHz]
Is=0mA
Is=20mA
Is=40mA
Is=60mA

FIG.11

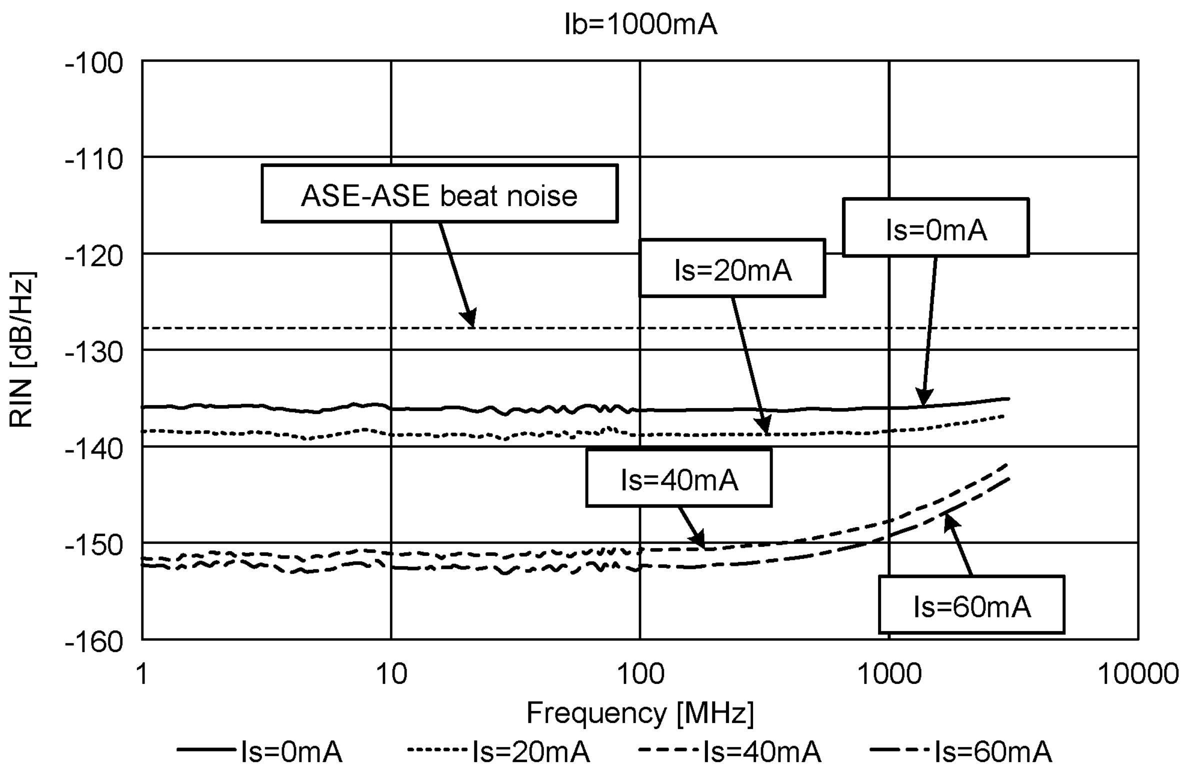
Ib=1000mA
-100
-110
-120
-130
-140
-150
-160
RIN [dB/Hz]
ASE-ASE beat noise
Is=0mA
Is=20mA
Is=40mA
Is=60mA
1
10
100
1000
10000
Frequency [MHz]
Is=0mA
Is=20mA
Is=40mA
Is=60mA

FIG.12

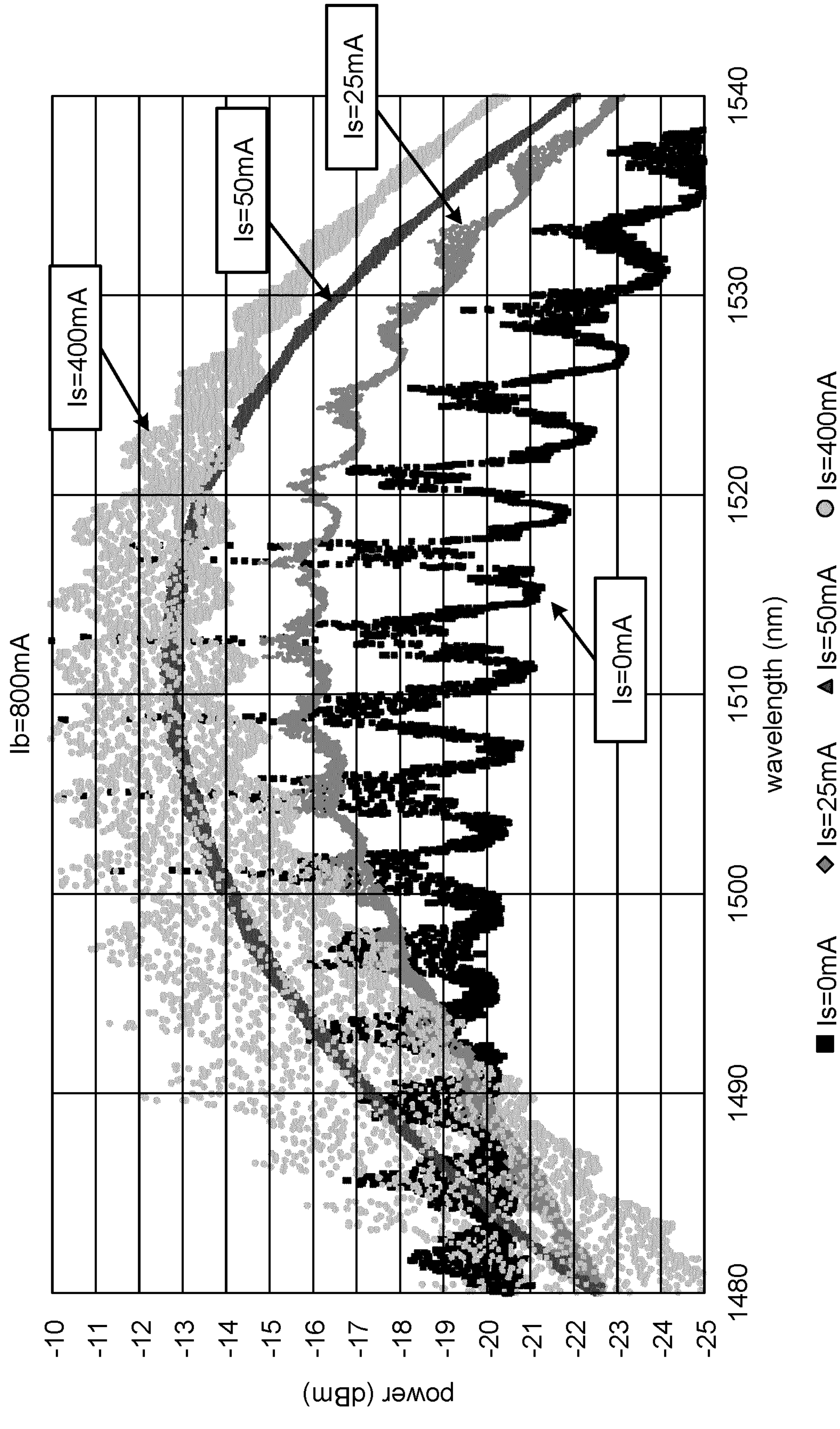
Ib=800mA
Is=400mA
Is=50mA
Is=25mA
Is=0mA
power (dBm)
-10
-11
-12
-13
-14
-15
-16
-17
-18
-19
-20
-21
-22
-23
-24
-25
1480
1490
1500
1510
1520
1530
1540
wavelength (nm)
■ Is=0mA ◆ Is=25mA ▲ Is=50mA ○ Is=400mA

FIG.13

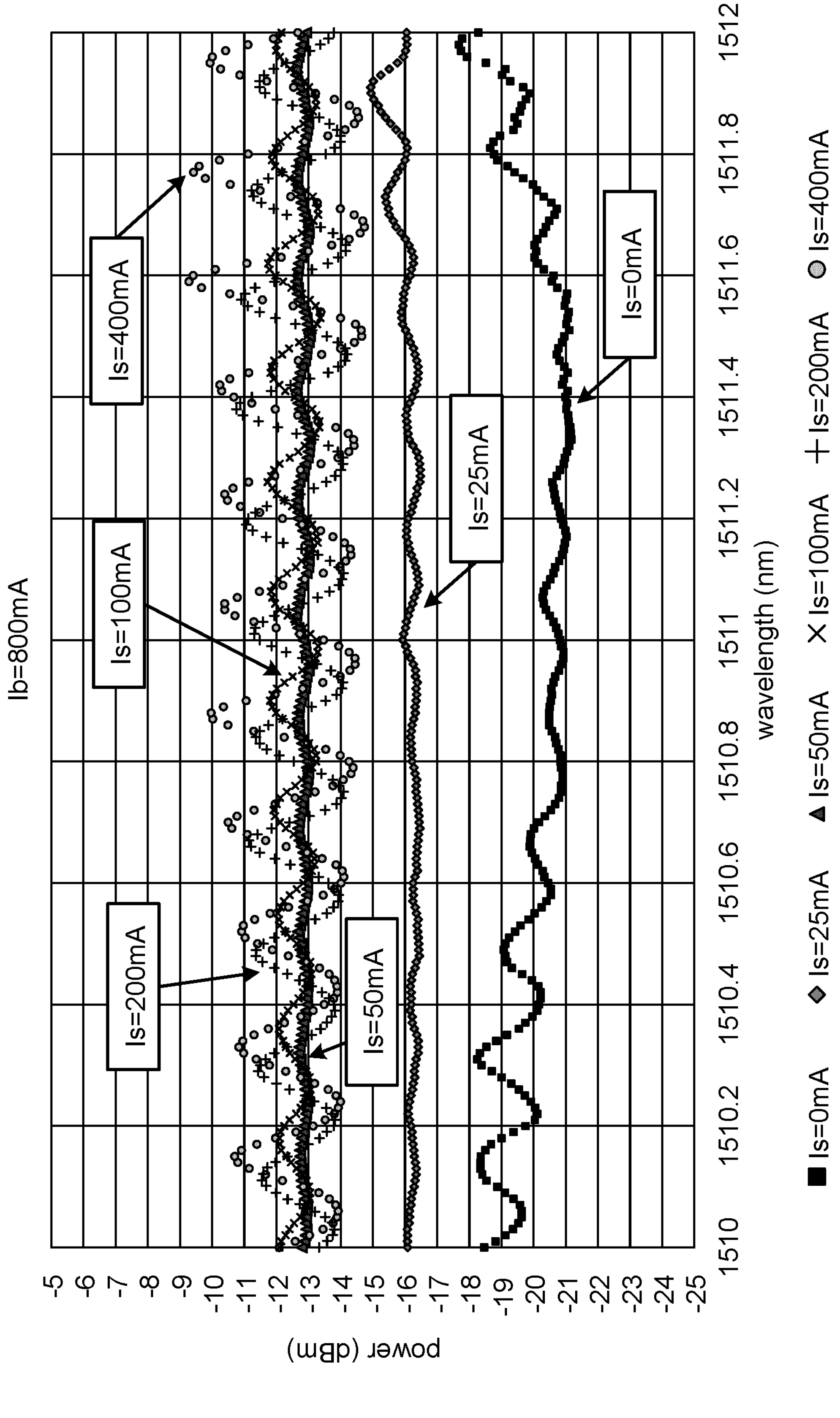
Ib=800mA
Is=400mA
Is=100mA
Is=200mA
Is=50mA
Is=25mA
Is=0mA
power (dBm)
wavelength (nm)
-5
-6
-7
-8
-9
-10
-11
-12
-13
-14
-15
-16
-17
-18
-19
-20
-21
-22
-23
-24
-25
1510
1510.2
1510.4
1510.6
1510.8
1511
1511.2
1511.4
1511.6
1511.8
1512
■ Is=0mA ◆ Is=25mA ▲ Is=50mA × Is=100mA + Is=200mA ● Is=400mA

FIG.14

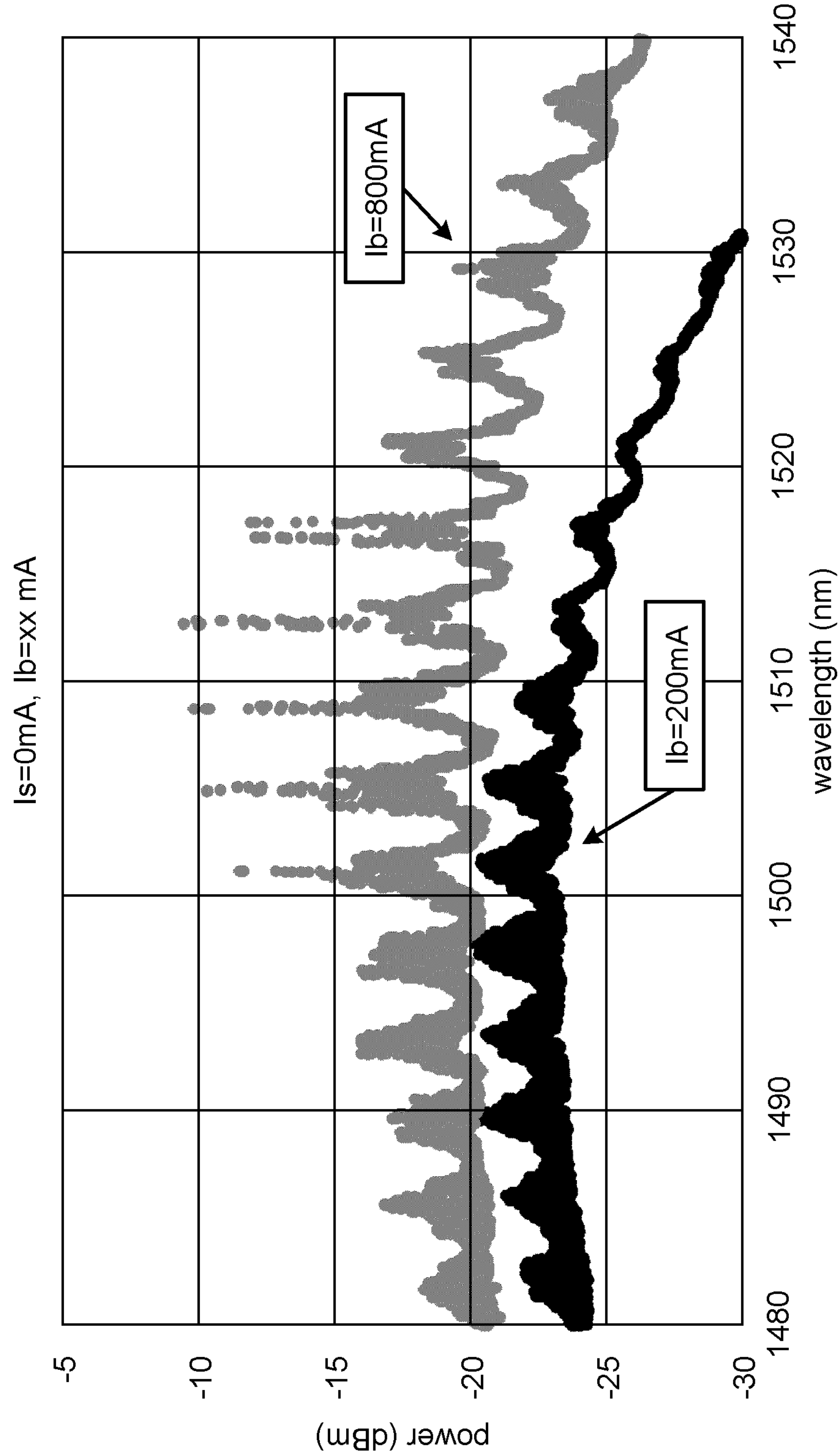
Is=0mA, Ib=xx mA
Ib=800mA
Ib=200mA
power (dBm)
-5
-10
-15
-20
-25
-30
wavelength (nm)
1480
1490
1500
1510
1520
1530
1540

FIG.15

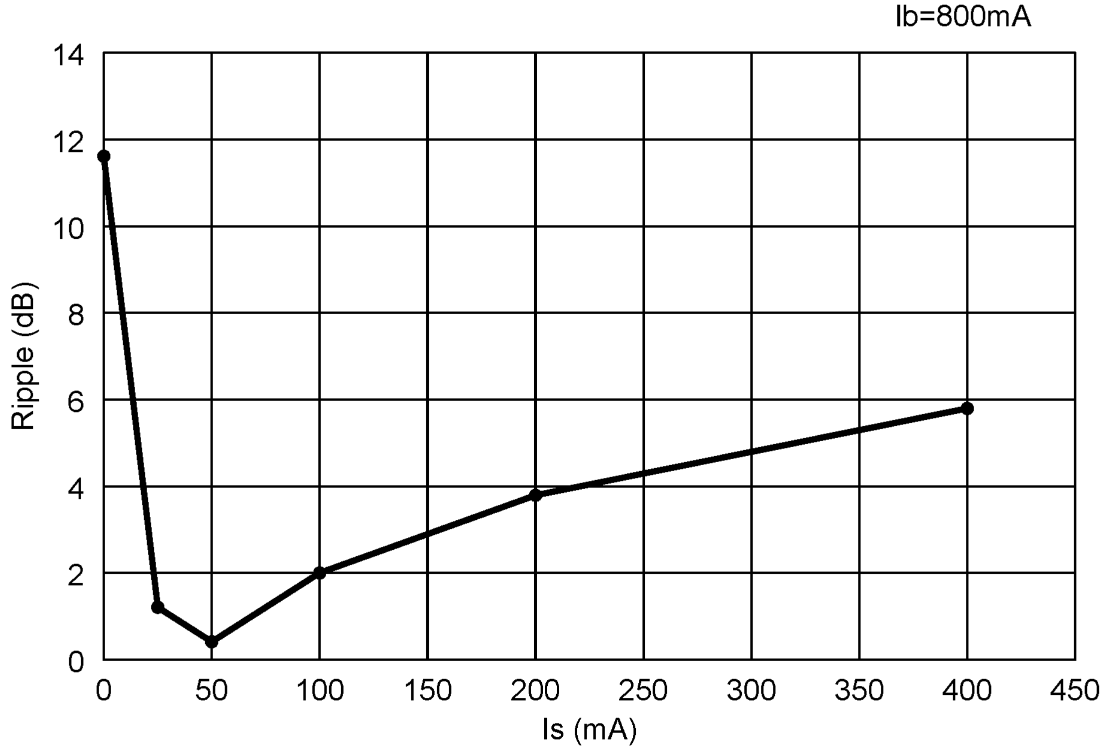
Ib=800mA
14
12
10
8
6
4
2
0
Ripple (dB)
0
50
100
150
200
250
300
350
400
450
Is (mA)

FIG.16

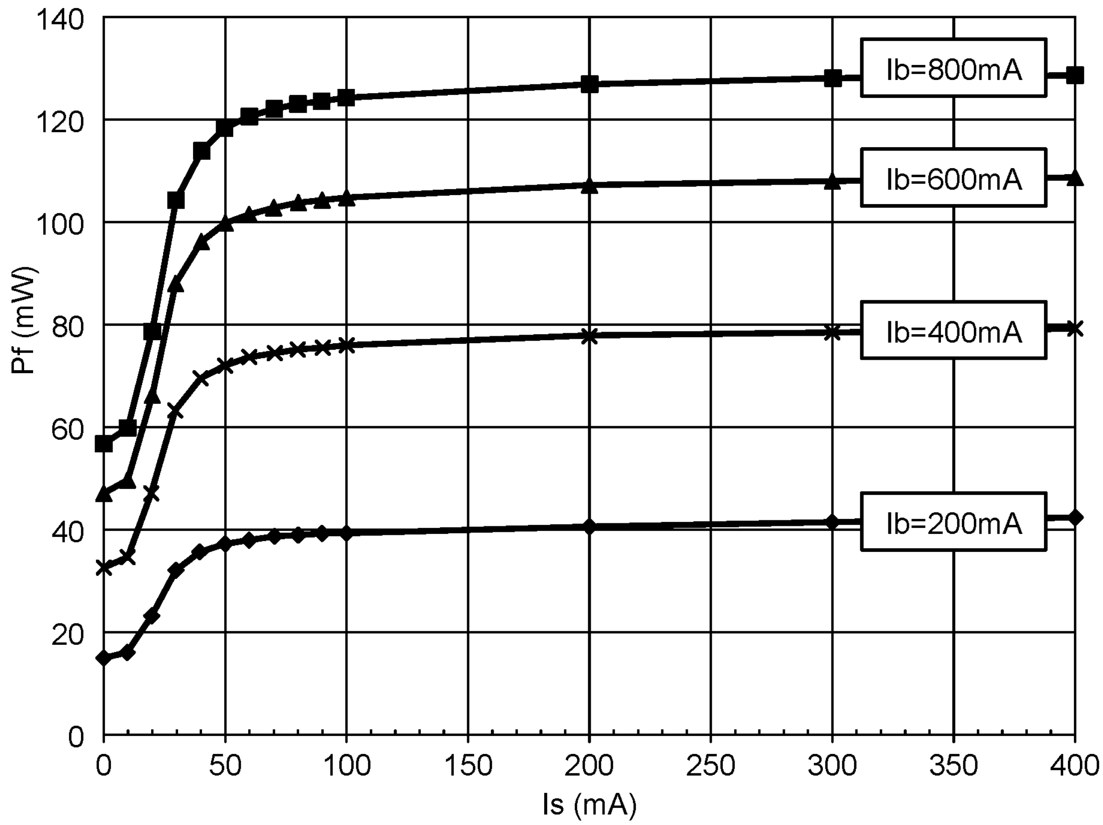
140
120
100
80
60
40
20
0
Pf (mW)
Ib=800mA
Ib=600mA
Ib=400mA
Ib=200mA
0
50
100
150
200
250
300
350
400
Is (mA)

FIG.17

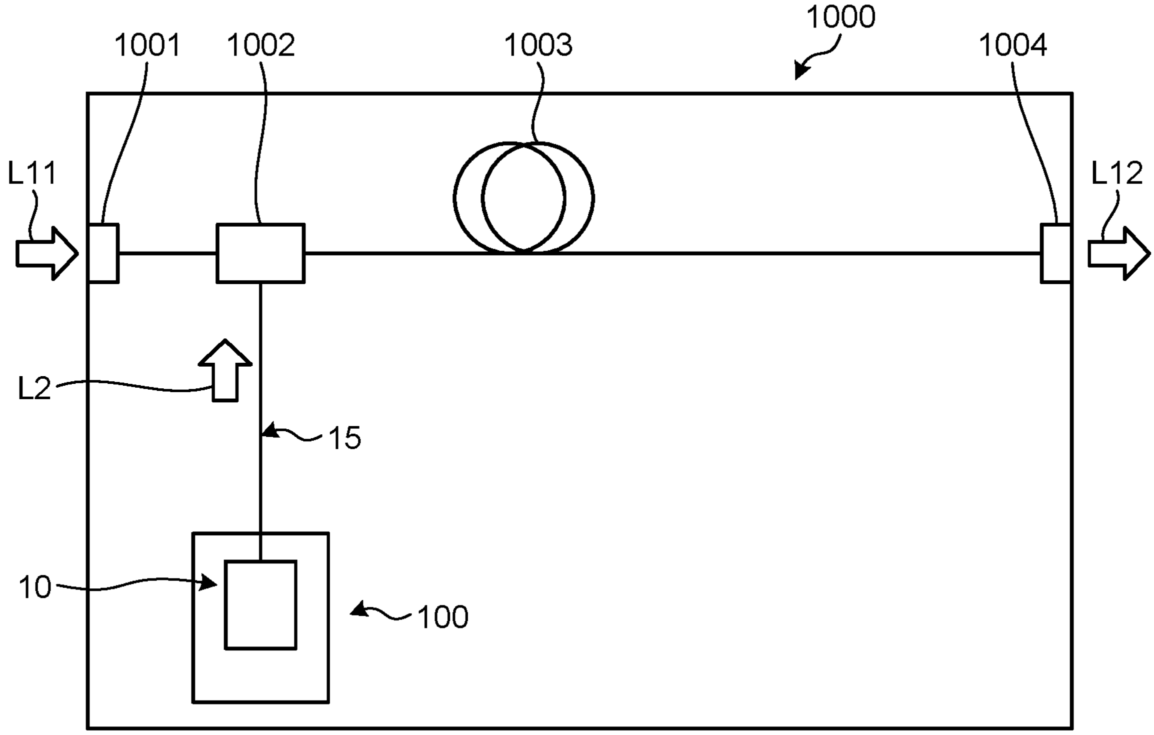
1000
1001
1002
1003
1004
L11
L12
L2
15
10
100

FIG.18

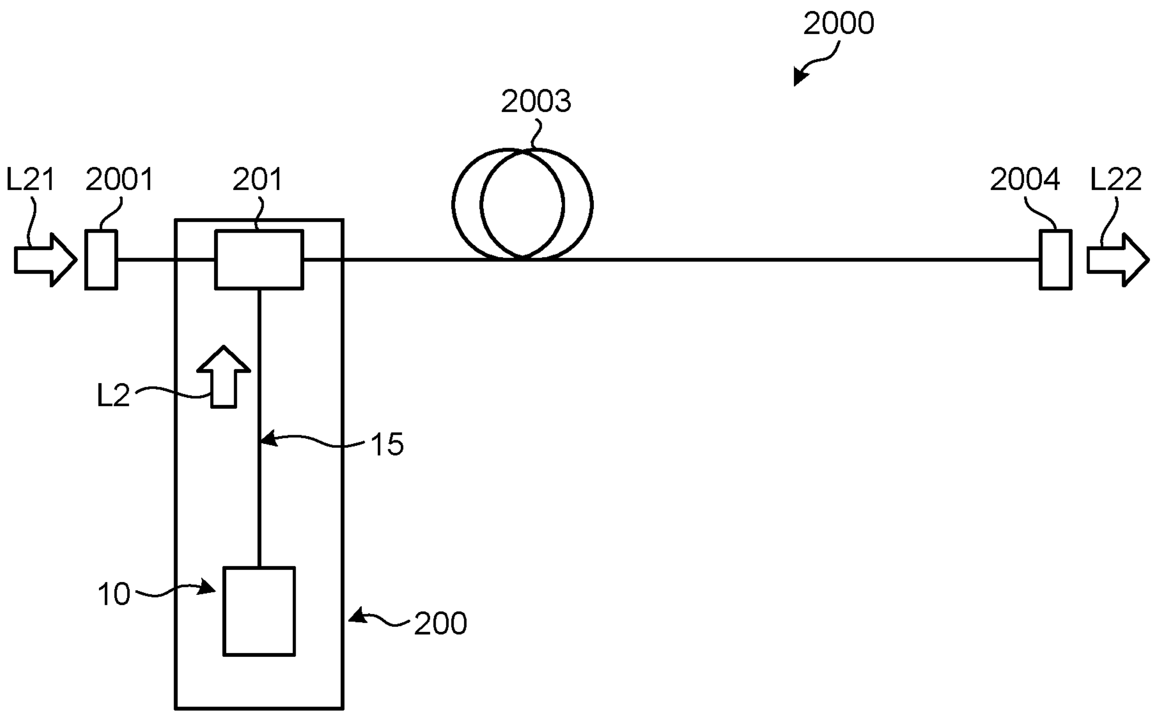
2000
2003
L21
2001
201
2004
L22
L2
15
10
200

INTERNATIONAL SEARCH REPORT

International application No.
**PCT/JP2021/033116**

**A. CLASSIFICATION OF SUBJECT MATTER**

***H01S 3/10***(2006.01)i; ***G02F 1/35***(2006.01)i; ***H01S 3/30***(2006.01)i; ***H01S 5/50***(2006.01)i
FI: H01S3/10 Z; G02F1/35 501; H01S3/30 Z; H01S5/50 610

According to International Patent Classification (IPC) or to both national classification and IPC

**B. FIELDS SEARCHED**

Minimum documentation searched (classification system followed by classification symbols)

H01S3/10; G02F1/35; H01S3/30; H01S5/50

Documentation searched other than minimum documentation to the extent that such documents are included in the fields searched

Published examined utility model applications of Japan 1922-1996
Published unexamined utility model applications of Japan 1971-2021
Registered utility model specifications of Japan 1996-2021
Published registered utility model applications of Japan 1994-2021

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | WO 2016/194556 A1 (HAMAMATSU PHOTONICS KK) 08 December 2016 (2016-12-08) paragraphs [0030]-[0049], [0059], fig. 2-10 | 1-13 |
| Y | JP 2005-123612 A (SAMSUNG ELECTRONICS CO., LTD.) 12 May 2005 (2005-05-12) paragraphs [0002]-[0008], [0013]-[0023], fig. 3-5 | 1-13 |
| Y | WO 2016/182068 A1 (FURUKAWA ELECTRIC CO., LTD.) 17 November 2016 (2016-11-17) paragraphs [0038]-[0054], fig. 1-3 | 12-13 |
| A | JP 2001-024227 A (NIPPON TELEGRAPH & TELEPHONE CORP.) 26 January 2001 (2001-01-26) paragraphs [0017]-[0026], fig. 5-8 | 1-13 |
| A | JP 2005-244231 A (SAMSUNG ELECTRONICS CO., LTD.) 08 September 2005 (2005-09-08) paragraphs [0013]-[0040], fig. 2-6 | 1-13 |
| A | JP 2013-516779 A (OCLARO TECHNOLOGY LTD.) 13 May 2013 (2013-05-13) paragraphs [0026]-[0049], fig. 3-6 | 1-13 |

☑ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **25 October 2021** | **09 November 2021** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

**INTERNATIONAL SEARCH REPORT**

International application No.
**PCT/JP2021/033116**

**C. DOCUMENTS CONSIDERED TO BE RELEVANT**

| Category* | Citation of document, with indication, where appropriate, of the relevant passages | Relevant to claim No. |
|---|---|---|
| A | US 2003/0039025 A1 (THE FURUKAWA ELECTRIC CO., LTD.) 27 February 2003 (2003-02-27) entire text, all drawings | 1-13 |
| A | US 2005/0259315 A1 (DEBUT, Alexis) 24 November 2005 (2005-11-24) entire text, all drawings | 1-13 |

Form PCT/ISA/210 (second sheet) (January 2015)

**INTERNATIONAL SEARCH REPORT**
**Information on patent family members**

International application No.
**PCT/JP2021/033116**

| Patent document cited in search report | Publication date (day/month/year) | Patent family member(s) | Publication date (day/month/year) |
|---|---|---|---|
| WO 2016/194556 A1 | 08 December 2016 | US 2018/0156860 A1<br>paragraphs [0030]-[0049], [0059], fig. 2-10<br>EP 3306761 A1<br>CN 107615603 A<br>KR 10-2018-0013937 A | |
| JP 2005-123612 A | 12 May 2005 | US 2005/0078359 A1<br>paragraphs [0004]-[0011], [0023]-[0028], fig. 3-5<br>KR 10-2005-0035580 A<br>CN 1607412 A | |
| WO 2016/182068 A1 | 17 November 2016 | US 2018/0123311 A1<br>paragraphs [0034]-[0050], fig. 1-3<br>CN 107533270 A | |
| JP 2001-024227 A | 26 January 2001 | (Family: none) | |
| JP 2005-244231 A | 08 September 2005 | US 2005/0185265 A1<br>paragraphs [0023]-[0048], fig. 2-6<br>KR 10-2005-0086175 A | |
| JP 2013-516779 A | 13 May 2013 | US 2011/0292496 A1<br>paragraphs [0031]-[0054], fig. 3-6<br>EP 2522057 A1<br>CN 102782968 A | |
| US 2003/0039025 A1 | 27 February 2003 | (Family: none) | |
| US 2005/0259315 A1 | 24 November 2005 | EP 1509976 A1<br>CA 2487148 A1<br>CN 1628401 A<br>AU 2002367993 A1 | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 20140153083
- US 07190861 B
- US 07215836 B
- US 07236295 B
- US 07173757 B
- JP 4069110 B
- US 10938175 B


### Non-patent literature cited in the description


- **PELOUCH, WAYNE S.** Raman amplification: An enabling technique for long-haul coherent transmission systems. *Journal of Lightwave Technology,* 2015, vol. 34 (1), 6-19
- **YAMAMOTO, Y. ; MACHIDA, S. ; NILSSON, O. A.** mplitude squeezing in a pump-noise-suppressed laser oscillator. *Physical Review A,* 1986, vol. 34 (5), 4025
- **KEITA, KAFING et al.** Relative intensity noise transfer of large-bandwidth pump lasers in Raman fiber amplifiers. *JOSA B,* 2006, vol. 23 (12), 2479-2485
- **FLUDGER, C. R. S. ; HANDEREK, V. ; MEARS, R. J.** Pump to signal RIN transfer in Raman fiber amplifiers. *Journal of Lightwave Technology,* 2001, vol. 19 (8), 1140
- Raman amplification using high-power incoherent semiconductor pump sources. **VAKHSHOORI, D. et al.** Optical Fiber Communication Conference. Optical Society of America, 2003, 47
- Noise suppression and intensity modulation using gain-saturated semiconductor optical amplifier. **YAMATOYA, T. ; KOYAMA, F. ; IGA, K.** Optical Amplifiers and Their Applications. Optical Society of America, 2000, 12
- **KOYAMA, F.** Conference Proceedings. LEOS'97. 10th Annual Meeting IEEE Lasers and Electro-Optics Society 1997 Annual Meeting. IEEE, 1997, 333-334
- **ZHAO, MINGSHAN ; MORTHIER, GEERT ; BAETS, ROEL.** Analysis and optimization of intensity noise reduction in spectrum-sliced WDM systems using a saturated semiconductor optical amplifier. *IEEE Photonics Technology Letters,* 2002, vol. 14 (3), 390-392
- **MORIMOTO, MASAHITO et al.** Co-propagating dual-order distributed Raman amplifier utilizing incoherent pumping. *IEEE Photonics Technology Letters,* 2017, vol. 29 (7), 567-570
- Co-propagating distributed Raman amplifier utilizing incoherent pumping. **MORIMOTO, MASAHITO et al.** Metro and Data Center Optical Networks and Short-Reach Links II. International Society for Optics and Photonics, 2019, 109460M
- 2nd-order forward-pumped distributed Raman amplification employing SOA-based incoherent light source in PDM-16QAM WDM transmission system. **KOBAYASHI, TAKAYUKI et al.** IEICE Communications Express. 2019
- PDM-16QAM WDM transmission with 2nd-order forward-pumped distributed Raman amplification utilizing incoherent pumping. **KOBAYASHI, TAKAYUKI et al.** Optical Fiber Communication Conference. Optical Society of America, 2019
- Broadband flat-noise Raman amplifier using low-noise bidirectionally pumping sources. **KADO, SOKO et al.** Proceedings 27th European Conference on Optical Communication (Cat. No. 01TH8551). IEEE, 2001, 38-39
- **EMORI, YOSHIHIRO ; KADO, SOKO ; NAMIKI, SHU.** Independent control of the gain and noise figure spectra of Raman amplifiers using bi-directional pumping. *Furukawa Review,* 2003, vol. 23, 11-15
- Fiber optic test and measurement. 1998